# EUROPEAN PATENT APPLICATION

(11) **EP 4 722 811 A1**
(43) Date of publication of application: **08.04.2026**
(21) Application number: 24811180.9
(22) Date of filing: 23.05.2024
(51) Int. Cl.: G03F 7/004, C08F 220/18, G03F 7/20, G03F 7/039

(54) **RESIST COMPOSITION AND PATTERN FORMING METHOD**

(30) Priority: 25.05.2023 JP 2023086234
(71) Applicant: TOKYO OHKA KOGYO CO., LTD., Kawasaki-shi, Kanagawa 211 0012 (JP)
(72) Inventor: INARI, Takatoshi, Kawasaki-shi, Kanagawa 211-0012 (JP); NODA, Kunihiro, Kawasaki-shi, Kanagawa 211-0012 (JP); KUBO, Keisuke, Kawasaki-shi, Kanagawa 211-0012 (JP); KIMURA, Kenta, Kawasaki-shi, Kanagawa 211-0012 (JP); NISHIZAWA, Akito, Kawasaki-shi, Kanagawa 211-0012 (JP); KINOSHITA, Yohei, Kawasaki-shi, Kanagawa 211-0012 (JP); WAKIYA, Kazumasa, Kawasaki-shi, Kanagawa 211-0012 (JP); NITTA, Kazuyuki, Kawasaki-shi, Kanagawa 211-0012 (JP)
(74) Representative: Plasseraud IP
(86) International application number: PCT/JP2024/019060
(87) International publication number: WO 2024/242175

(57) **Abstract**

To provide a novel resist composition containing (A) a resin component whose solubility in a developer changes by the action of an acid and (B) a polyacid salt, and to provide a pattern forming method thereof.

## Description

### Technical Field

The present invention relates to a resist composition and pattern forming method.

### Background Art

A microfabrication technique called lithography is used to form a fine circuit of a semiconductor element. The lithography technique is a technique of transferring a circuit pattern drawn on an original mask onto a resist on a substrate via an exposure apparatus.

The resist used in the lithography is required to have characteristics such as high sensitivity to an exposure light source of the exposure apparatus and high resolution for reproducing a fine dimensional pattern.

However, a so-called trade-off relationship between sensitivity and resolution has been pointed out that the resolution is deteriorated when the sensitivity of a resist to an exposure light source is improved, and it has been a difficult problem to keep a balance between the sensitivity and the resolution in a resist.

Thus, research and development of a novel resist composition according to the type of exposure light source have been conducted.

For example, Patent Literature 1 discloses an invention relating to a radiation-sensitive composition containing a polymetalloxane (a germanium atom, a tin atom, or a lead atom) having a predetermined structural unit, a radiation-sensitive acid generator, and a solvent, as a radiation-sensitive composition with high sensitivity and resolution.

### Citation List

### Patent Literature

PTL 1: U.S. Patent No. 11506976

### Summary of Invention

### Technical Problem

The present invention has been made in view of such circumstances and aims to provide a novel resist composition and a novel pattern forming method.

### Solution to Problem

As a result of extensive studies to solve the above problems, the present inventors have completed the present invention by finding that, in a resist composition containing (A) a resin component whose solubility in a developer changes by the action of an acid and (B) a polyacid salt, the strong acidity in an exposed portion of the resist composition, the solubility of the resist composition in a developer, and the like can be adjusted by changing the structure of an anion moiety and/or a cation moiety of the component (B).

More specifically, the present invention relates to the following inventions.
[1] A resist composition containing (A) a resin component whose solubility in a developer changes by the action of an acid and (B) a polyacid salt.
[2] The resist composition according to [1], wherein an anion moiety of the (B) polyacid salt is a polyoxomolybdate anion, a polyoxotungstate anion, a polyoxoniobate anion, or a polyoxotantalate anion.
[3] The resist composition according to [1], wherein a cation moiety of the (B) polyacid salt is an organic sulfonium cation, an organic iodonium cation, or an organic quaternary ammonium cation.
[4] The resist composition according to [1], wherein the (B) polyacid salt is a salt of a polyoxomolybdate anion, a polyoxotungstate anion, a polyoxoniobate anion, or a polyoxotantalate anion, and an organic sulfonium cation, an organic iodonium cation, or an organic quaternary ammonium cation.
[5] The resist composition according to [1], further containing (C) an acid generator or an acid diffusion control agent.
[6] A pattern forming method including the steps of:
   applying the resist composition according to any one of [1] to [5] to a substrate to form a resist film;
   exposing the resist film to light; and
   developing the exposed resist film with a developer.

### Advantageous Effects of Invention

The present invention can provide a novel resist composition and a pattern forming method. A resist composition according to the present invention contains a polyacid salt that can highly absorb a light source, such as DUV, XUV, EUV, or an electron beam, as the component (B) and can therefore be suitably used as a resist composition for these exposure light sources.

### Description of Embodiments

Preferred embodiments of the present invention will be described in detail below. However, the present invention is not limited to the following embodiments.

### [1. Resist Composition]

A resist composition according to the present embodiment contains (A) a resin component whose solubility in a developer changes by the action of an acid, and (B) a polyacid salt. Furthermore, a resist composition according to another embodiment may further contain (C) an acid generator or an acid diffusion control agent, in addition to the component (A) and the component (B).

Meanings of terms, symbols, and the like used in the present description will be described below, and embodiments of the present invention will be described in more detail below.

The term "halogen atom", as used herein, refers to a fluorine atom, a chlorine atom, a bromine atom, or an iodine atom.

In the present description, for example, the term "C₁₋₆" or the like means the number of carbon atoms of a group serving as a mother nucleus.

The term "C₁₋₁₈ hydrocarbylene group", as used herein, refers to a divalent hydrocarbon group formed by removing two hydrogen atoms from a hydrocarbon with 1 to 18 carbon atoms. The hydrocarbylene group may be linear, branched, or partially or fully cyclic. Examples of the hydrocarbylene group include an alkylene group and an arylene group.

A divalent carbon atom at any position of the "C₁₋₁₈ hydrocarbylene group" may be replaced by -O-, -S-, -C(=O)-, -COO-, -OCO-, -CONH-, -NHCO-, -NH(C=O)O-, -S-, -SO-, or - SO₂- (provided that adjacent divalent carbon atoms are not replaced at the same time).

The "C₁₋₁₈ hydrocarbylene group" is, for example, but not limited to, a "C₁₋₁₈ alkylene group", such as a methylene group, an ethylene group, a n-propylene group, an i-propylene group, a cyclopentadiyl group, a cyclohexanediyl group, an oxyethane-1,1-diyl group, an oxyethane-1,2-diyl group, an oxypropane-1,3-diyl group, an oxypropane-1,2-diyl group, a 2-methylpropane-1,3-diyl group, or an oxyethyleneoxyethane-1,1-diyl group; a "C₆₋₁₈ arylene group", such as a 1,4-phenylene group, a 1,3-phenylene group, a 1,2-phenylene group, a 1,4-naphthylene group, a 1,5-naphthylene group, a 1,8-naphthylene group, a 4,4'-biphenylene group, an anthracenediyl group, a phenanthrenediyl group, a naphthacenediyl group, a pyrenediyl group, a perylenediyl group, or a chrysenediyl group; or the like.

The term "C₁₋₁₈ alkyl group", as used herein, refers to a linear or branched alkyl group with 1 to 18 carbon atoms.

Furthermore, a divalent carbon atom at any position excluding the terminals contained in the "C₁₋₁₈ alkyl group" may be replaced by -O-, -C(=O)-, -C(=O)O-, -OCO-, -CONH-, -NHCO-, -NH(C=O)O-, -S-, or -SO₂-. However, adjacent divalent carbon atoms are not replaced at the same time.

The "C₁₋₁₈ alkyl group" is, for example, but not limited to, a methyl group, an ethyl group, a n-propyl group, an i-propyl group, a n-butyl group, an i-butyl group, a sec-butyl group, a t-butyl group, a n-pentyl group, an i-pentyl group, a sec-pentyl group, a t-pentyl group, a neopentyl group, a 1-methylbutyl group, a 2-methylbutyl group, a 1,1-dimethylpropyl group, a 1,2-dimethylpropyl group, a n-hexyl group, an i-hexyl group, a 1-methylpentyl group, a 2-methylpentyl group, a 3-methylpentyl group, a 1,1-dimethylbutyl group, a 1,2-dimethylbutyl group, a 2,2-dimethylbutyl group, a 1,3-dimethylbutyl group, a 2,3-dimethylbutyl group, a 3,3-dimethylbutyl group, a 1-ethylbutyl group, a 2-ethylbutyl group, a 1,1,2-trimethylpropyl group, a 1,2,2-trimethylpropyl group, a 1-ethyl-1-methylpropyl group, a 1-ethyl-2-methylpropyl group, a n-heptyl group, a n-octyl group, a n-nonyl group, a n-decyl group, a n-undecyl group, a n-dodecyl group, or the like.

The "C₁₋₁₈ alkyl group" in which a divalent carbon atom at any position excluding the terminals thereof is replaced by -O-, -C(=O)-, -C(=O)O-, -OCO-, -CONH-, -NHCO-, - NH(C=O)O-, -S-, or -SO₂- is, for example, but not limited to, a 2-methoxyethoxymethyl group, an ethoxycarbonylmethyl group, or the like.

The term "C₁₋₁₈ haloalkyl group", as used herein, refers to a group in which one or more hydrogen atoms of the "C₁₋₁₈ alkyl group" are substituted by a halogen atom.

The "C₁₋₁₈ haloalkyl group" is, for example, but not limited to, a dichloromethyl group, a trifluoromethyl group, a 2,2-difluoroethyl group, a 2,2,2-trifluoroethyl group, a pentafluoroethyl group, a 3,3,3-trifluoropropyl group, or the like.

The term "C₂₋₁₈ alkenyl group", as used herein, refers to an alkenyl group with 2 or more carbon atoms having one or more double bonds in the "C₁₋₁₈ alkyl group" and includes an alkadienyl group, an alkatrienyl group, and the like.

The "C₂₋₁₈ alkenyl group" is, for example, but not limited to, a vinyl group (ethenyl group), an allyl group (2-propenyl group), a 1-propenyl group, an isopropenyl group (1-methyl vinyl group), a 1-butenyl group, a 2-butenyl group, a 3-butenyl group, a pentenyl group, a hexenyl group, a heptenyl group, an octenyl group, a nonenyl group, a decenyl group, an undecenyl group, a dodecenyl group, or the like.

The term "C₂₋₁₈ alkynyl group", as used herein, refers to an alkynyl group with 2 or more carbon atoms having one or more triple bonds in the "C₁₋₁₈ alkyl group".

The "C₂₋₁₈ alkynyl group" is, for example, but not limited to, an ethynyl group, a 1-propynyl group, a 2-propynyl group, a pentynyl group, a hexynyl group, a heptynyl group, an octynyl group, a nonynyl group, a decynyl group, an undecynyl group, a dodecynyl group, or the like.

The term "C₃₋₁₈ alicyclic group", as used herein, refers to a hydrocarbon group with 3 to 18 carbon atoms and with a monocyclic or polycyclic structure in whole or in part. The alicyclic group includes a cycloalkyl group, a cycloalkenyl group, a cycloalkynyl group, a monocycloalkyl group, a polycycloalkyl group, and the like.

A divalent carbon atom at any position excluding the terminals contained in the "C₃₋₁₈ alicyclic group" may be replaced by -O-, -C(=O)-, -C(=O)O-, -OCO-, -CONH-, -NHCO-, - NH(C=O)O-, -S-, or -SO₂- (provided that adjacent divalent carbon atoms are not replaced at the same time).

The "C₃₋₁₈ cycloalkyl group" is, for example, but not limited to, a cyclopropyl group, a cyclobutyl group, a cyclopentyl group, a 1-i-propylcyclopentane-1-yl group, a cyclohexyl group, a t-butylcyclohexyl group, a tricyclodecanyl group, a cycloheptyl group, a cyclooctyl group, a cyclodecyl group, a 2-methyladamantane-2-yl group, a 2-i-propyladamantane-2-yl group, a bornyl group, a norbonyl group, a fenchyl group, a pinanyl group, an adamantyl group, a tricyclodecyl group, a tetracyclododecyl group, a cyclopropylmethyl group, a cyclobutylmethyl group, a cyclopentylmethyl group, a cyclohexylmethyl group, a bornylmethyl group, a norbornylmethyl group, an adamantylmethyl group, a 1-methylcyclopentyloxycarbonylmethyl group, a cyclopentenyl group, a cyclohexenyl group, a cycloheptenyl group, or the like.

The term "3- to 18-membered non-aromatic heterocyclic group", as used herein, refers to a 3- to 18-membered non-aromatic heterocyclic group containing one or more heteroatoms selected from the group consisting of a nitrogen atom, an oxygen atom, and a sulfur atom, may be monocyclic, polycyclic, or condensed, and may be saturated or partially unsaturated.

The "3- to 18-membered non-aromatic heterocyclic group" is, for example, but not limited to, an aziridinyl group, an azetidil group, a pyrrolidinyl group, a pyrrolyl group, a piperidinyl group, a piperazinyl group, a morpholinyl group, a thiomorpholinyl group, a tetrahydrofuryl group, a tetrahydropyranyl group, an oxetanyl group, a tetrahydrofuryl group, a tetrahydropyranyl group, an imidazolinyl group, an oxazolinyl group, a 2,5-diazabicyclo[2.2.1]heptyl group, a 2,5-diazabicyclo[2.2.2]octyl group, a 3,8-diazabicyclo[3.2.1]octyl group, a 1,4-diazabicyclo[4.3.0]nonyl group, a 1-azaadamantyl group, a 2-azaadamantyl group, or the like.

The term "C₂₋₁₈ aryl group", as used herein, refers to an aromatic hydrocarbon ring group with 6 to 18 carbon atoms or an aromatic heterocyclic group with 2 to 10 carbon atoms; in the case of an aromatic heterocyclic group, 2 to 10 carbon atoms and one or more heteroatoms selected from the group consisting of a nitrogen atom, an oxygen atom, and an oxygen atom form a ring, and the ring may be monocyclic, polycyclic, or a fused ring.

The "C₂₋₁₈ aryl group" is, for example, but not limited to, a phenyl group, a 1-naphthyl group, a 2-naphthyl group, an azulenyl group, a pentalenyl group, a heptalenyl group, an indacenyl group, an acenaphthyl group, a phenanthrenyl group, an anthracenyl group, or the like.

The term "C₇₋₁₈ aralkyl group", as used herein, refers to a group in which a substitutable portion of a "C₁₋₁₂ alkyl group" is substituted by the "C₂₋₁₂ aryl group".

The "C₇₋₁₈ aralkyl group" is, for example, but not limited to, a benzyl group, a phenethyl group, a 3-phenylpropyl group, a 4-phenylbutyl group, a 1-naphthylmethyl group, or a 2-naphthylmethyl group, or the like.

The term "C₁₋₁₈ hydrocarbyl group", as used herein, refers to a monovalent group formed by removing one hydrogen atom from a hydrocarbon with 1 to 18 carbon atoms. Examples of the hydrocarbyl group include an alkyl group, an alkenyl group, an alkynyl group, an alicyclic group, an aryl group, an aralkyl group, and the like.

A divalent carbon atom at any position excluding the terminals contained in the "C₁₋₁₈ hydrocarbyl group" may be replaced by -O-, -C(=O)-, -C(=O)O-, -OCO-, -CONH-, -NHCO-, - NH(C=O)O-, -S-, or -SO₂- (provided that adjacent divalent carbon atoms are not replaced at the same time). The same applies to the "C₁₋₁₈ hydrocarbyl group" and the like used in the following description of the definition of the "C₁₋₁₈ hydrocarbyloxy group" and the like.

The "C₁₋₁₈ hydrocarbyl group" is, for example, but not limited to, a "C₁₋₁₈ alkyl group", a "C₂₋₁₈ alkenyl group", a "C₂₋₁₈ alkynyl group", a "C₃₋₁₈ alicyclic group", a "C₂₋₁₈ aryl group", a "C₇₋₁₈ aralkyl group", or the like.

The term "C₁₋₁₈ hydrocarbyloxy group", as used herein, refers to a group in which an oxygen atom (-O-) is bonded to the "C₁₋₁₈ hydrocarbyl group".

The "C₁₋₁₈ hydrocarbyloxy group" is, for example, but not limited to, a "C₁₋₁₈ alkoxy group", such as a methoxy group, an ethoxy group, a n-propoxy group, an i-propoxy group, a n-butoxy group, an i-butoxy group, a sec-butoxy group, a t-butoxy group, a n-pentoxy group, an i-pentoxy group, a sec-pentoxy group, a n-hexoxy group, an i-hexoxy group, a 1,1-dimethylpropyloxy group, a 1,2-dimethylpropyloxy group, a 2,2-dimethylpropyloxy group, a 1-methyl-2-ethylpropyloxy group, a 1-ethyl-2-methylpropyloxy group, a 1,1,2-trimethylpropyloxy group, a 1,2,2-trimethylpropyloxy group, a 1,1-dimethylbutyloxy group, a 1,2-dimethylbutyloxy group, a 2,2-dimethylbutyloxy group, a 2,3-dimethylbutyloxy group, a 1,3-dimethylbutyloxy group, a 2-ethylbutyloxy group, a 2-methylpentyloxy group, or a 3-methylpentyloxy group; a "C₃₋₁₈ alicyclic oxy group", such as a cyclopropyloxy group, a cyclobutyloxy group, a cyclopentyloxy group, a cyclohexyloxy group, a cycloheptyloxy group, a cyclooctyloxy group, a 1-methylcyclopentyloxycarbonylmethoxy group, a 1-ethylcyclohexyloxycarbonylmethoxy group, or a 1-methyladamantyloxycarbonylmethoxy group; a "C₆₋₁₈ aryloxy group", such as a phenyloxy group, a 1-naphthyloxy group, a 2-naphthyloxy group, an azulenyloxy group, a pentalenyloxy group, a heptalenyloxy group, an indacenyloxy group, an acenaphthyloxy group, a phenanthrenyloxy group, or an anthracenyloxy group; or the like.

In the "C₁₋₁₈ hydrocarbyloxy group", a divalent carbon atom at any position excluding the terminals in the "C₁₋₁₈ hydrocarbyl group" is preferably replaced by -O-, -C(=O)-, and/or - C(=O)O-, the "C₁₋₁₈ hydrocarbyloxy group" is more preferably a "C₁₋₁₈ hydrocarbyloxycarbonylalkyloxy group", and from the perspective of solubility, a carbon atom bonded to the oxygen atom of the hydrocarbyloxy is still more preferably a tertiary carbon. Specific examples of the hydrocarbyloxy include optionally substituted ethylcyclopentyloxy, methyladamantyloxy, ethyladamantyloxy, t-butyloxy, and the like.

The term "C₁₋₁₈ hydrocarbylcarbonyl group", as used herein, refers to a group in which a carbonyl group (-C(=O)-) is bonded to the "C₁₋₁₈ hydrocarbyl group".

The "C₁₋₁₈ hydrocarbylcarbonyl group" is, for example, but not limited to, a "C₁₋₁₈ alkyl carbonyl group", such as an acetyl group, a propionyl group, an isopropionyl group, a butyryl group, an isobutyryl group, a valeryl group, an isovaleryl group, a pentanoyl group, a 3-methylbutanoyl group, a pivaloyl group, a hexanoyl group, or a heptanoyl group; a "C₃₋₁₈ alicyclic carbonyl group", such as a cyclopropyl carbonyl group, a cyclobutyl carbonyl group, a cyclopentyl carbonyl group, a 2-methylcyclopentyl carbonyl group, a 3-methylcyclopentyl carbonyl group, a cyclohexyl carbonyl group, a 2-methylcyclohexyl carbonyl group, a 3-methylcyclohexyl carbonyl group, a 4-methylcyclohexyl carbonyl group, or an adamantyl carbonyl group; a "C₆₋₁₈ aryl carbonyl group", such as a benzoyl group, a 1-naphthoyl group, or a 2-naphthoyl group; or the like.

The term "C₁₋₁₈ hydrocarbylcarbonyloxy group", as used herein, refers to a group in which an oxygen atom (-O-) is bonded to the "C₁₋₁₈ hydrocarbylcarbonyl group".

The "C₁₋₁₈ hydrocarbylcarbonyloxy group" is, for example, but not limited to, a "C₁₋₁₈ alkyl carbonyloxy group", such as a methyl carbonyloxy group, an ethyl carbonyloxy group, a n-propyl carbonyloxy group, an isopropyl carbonyloxy group, a n-butyl carbonyloxy group, an isobutyl carbonyloxy group, a t-butyl carbonyloxy group, a n-pentyl carbonyloxy group, an isopentyl carbonyloxy group, or a hexyl carbonyloxy group; a "C₃₋₁₈ alicyclic carbonyloxy group", such as a cyclopropyl carbonyloxy group, a cyclobutyl carbonyloxy group, a cyclopentyl carbonyloxy group, or a cyclohexyl carbonyloxy group; a "C₆₋₁₈ aryl carbonyloxy group", such as a phenyl carbonyloxy group, a naphthyl carbonyloxy group, an acenaphthyl carbonyloxy group, a phenanthrenyl carbonyloxy group, or an anthracenyl carbonyloxy group; or the like.

The term "C₁₋₁₈ hydrocarbyloxycarbonyl group", as used herein, refers to a group in which a carbonyl group (-C(=O)-) is bonded to a "C₁₋₁₈ hydrocarbyloxy group".

The "C₁₋₁₈ hydrocarbyloxycarbonyl group" is, for example, but not limited to, a "C₁₋₁₈ alkoxycarbonyl group", such as a methoxycarbonyl group, an ethoxycarbonyl group, a n-propoxycarbonyl group, an i-propoxycarbonyl group, a n-butoxycarbonyl group, an i-butoxycarbonyl group, a sec-butoxycarbonyl group, a t-butoxycarbonyl group, a n-pentoxycarbonyl group, or a neopentyloxycarbonyl group; a "C₃₋₁₈ alicyclic oxycarbonyl group", such as a cyclopropyloxycarbonyl group, a cyclobutyloxycarbonyl group, a cyclopentyloxycarbonyl group, a cyclohexyloxycarbonyl group, a 2-methylcyclopentyloxycarbonyl group, a 3-methylcyclopentyloxycarbonyl group, a 2-methylcyclohexyloxycarbonyl group, a 3-methylcyclohexyloxycarbonyl group, or a 4-methylcyclohexyloxycarbonyl group; a "C₆₋₁₈ aryloxycarbonyl group", such as a phenoxycarbonyl group, a naphthoxycarbonyl group, an acenaphthyloxycarbonyl group, a phenanthrenyloxycarbonyl group, or an anthracenyloxycarbonyl group; or the like.

The term "C₁₋₁₈ hydrocarbyloxycarbonyloxy group", as used herein, refers to a group in which an oxygen atom (-O-) is bonded to the "C₁₋₁₈ hydrocarbyloxycarbonyl group".

The "C₁₋₁₈ hydrocarbyloxycarbonyloxy group" is, for example, but not limited to, a "C₁₋₁₈ alkoxycarbonyloxy group", such as a methoxycarbonyloxy group, an ethoxycarbonyloxy group, a n-propyloxycarbonyloxy group, an i-propyloxycarbonyloxy group, a n-butoxycarbonyloxy group, an i-butoxycarbonyloxy group, a sec-butoxycarbonyloxy group, a t-butoxycarbonyloxy group, a n-pentyloxycarbonyloxy group, an i-pentyloxycarbonyloxy group, or a n-hexyloxycarbonyloxy group; a "C₃₋₁₈ alicyclic oxycarbonyloxy group", such as a cyclopropyloxycarbonyloxy group, a cyclobutyloxycarbonyloxy group, a cyclopentyloxycarbonyloxy group, or a cyclohexyloxycarbonyloxy group; a "C₆₋₁₈ aryloxycarbonyloxy group", such as a phenoxycarbonyloxy group, a naphthoxycarbonyloxy group, an acenaphthyloxycarbonyloxy group, a phenanthrenyloxycarbonyloxy group, or an anthracenyloxycarbonyloxy group; or the like.

The term "C₁₋₁₈ hydrocarbylamino group", as used herein, refers to a group in which one "C₁₋₁₈ hydrocarbyl group" is bonded to an amino group.

The "C₁₋₁₈ hydrocarbylamino group" is, for example, but not limited to, a "C₁₋₁₈ alkylamino group", such as a methylamino group, an ethylamino group, a n-propylamino group, an i-propylamino group, a n-butylamino group, an i-butylamino group, a sec-butylamino group, a t-butylamino group, a n-pentylamino group, an i-pentylamino group, a neopentylamino group, or a n-hexylamino group; a "C₃₋₁₈ alicyclic amino group", such as a cyclopropylamino group, a cyclobutylamino group, a cyclopentylamino group, a 2-methylcyclopentylamino group, a 3-methylcyclopentylamino group, a cyclohexylamino group, a 2-methylcyclohexylamino group, a 3-methylcyclohexylamino group, or a 4-methylcyclohexylamino group; a "C₆₋₁₈ arylamino group", such as a phenylamino group, a 1-naphthylamino group, or a 2-naphthylamino group; or the like.

The term "di-C₁₋₁₈ hydrocarbylamino group", as used herein, refers to a group in which two identical or different "C₁₋₁₈ hydrocarbyl groups" are bonded to an amino group.

The "di-C₁₋₁₈ hydrocarbylamino group" is, for example, but not limited to, a "di-C₁₋₁₈ alkylamino group", such as a dimethylamino group, a diethylamino group, a di-n-propylamino group, a diisopropylamino group, a di-n-butylamino group, a diisobutylamino group, a di-t-butylamino group, a di-n-pentylamino group, a di-n-hexylamino group, an N-ethyl-N-methylamino group, an N-methyl-N-n-propylamino group, an N-isopropyl-N-methylamino group, an N-n-butyl-N-methylamino group, an N-isobutyl-N-methylamino group, an N-t-butyl-N-methylamino group, an N-methyl-N-n-pentylamino group, an N-n-hexyl-N-methylamino group, an N-ethyl-N-n-propylamino group, an N-ethyl-N-isopropylamino group, an N-n-butyl-N-ethylamino group, an N-ethyl-N-isobutylamino group, an N-t-butyl-N-ethylamino group, an N-ethyl-N-n-pentylamino group, or an N-ethyl-N-n-hexylamino group; a "di-C₃₋₁₈ alicyclic amino group", such as a dicyclopropylamino group, a dicyclobutylamino group, a dicyclopentylamino group, or a dicyclohexylamino group; a "di-C₆₋₁₈ arylamino group", such as a diphenylamino group or a phenylnaphthylamino group; an "N-C₁₋₁₈ alkyl-N-C₃₋₁₈ cycloalkylamino group", such as an N-methylcyclopentaneamino group or an N-methylcyclohexylamino group; an "N-C₁₋₁₈ alkyl-N-C₆₋₁₈ arylamino group", such as an N-methyl-2-phenylethylamino group or an N-ethyl-N-(4-methylphenyl)amino group; or the like.

The term "C₁₋₁₈ hydrocarbylaminocarbonyl group", as used herein, refers to a group in which a carbonyl group (-C(=O)-) is bonded to the "C₁₋₁₈ hydrocarbylamino group".

The "C₁₋₁₈ hydrocarbylaminocarbonyl group" is, for example, but not limited to, a "C₁₋₁₈ alkylaminocarbonyl group", such as a methylaminocarbonyl group, an ethylaminocarbonyl group, a n-propylaminocarbonyl group, an i-propylaminocarbonyl group, a n-butylaminocarbonyl group, a sec-butylaminocarbonyl group, a t-butylaminocarbonyl group, a n-pentylaminocarbonyl group, a 2-pentylaminocarbonyl group, a neopentylaminocarbonyl group, a 4-methyl-2-pentylaminocarbonyl group, a n-hexylaminocarbonyl group, or a 3-methyl-n-pentylaminocarbonyl group; a "C₃₋₁₈ alicyclic aminocarbonyl group", such as a cyclopropylaminocarbonyl group, a cyclobutylaminocarbonyl group, a cyclopentylaminocarbonyl group, a cyclohexylaminocarbonyl group, a 2-methylcyclopentylaminocarbonyl group, a 3-methylcyclopentylaminocarbonyl group, a 2-methylcyclohexylaminocarbonyl group, a 3-methylcyclohexylaminocarbonyl group, or a 4-methylcyclohexylaminocarbonyl group; or a "C₆₋₁₈ arylaminocarbonyl group", such as a phenylaminocarbonyl group, a 1-naphthylaminocarbonyl group, or a 2-naphthylaminocarbonyl group.

The term "di-C₁₋₁₈ hydrocarbylaminocarbonyl group", as used herein, refers to a group in which a carbonyl group (-C(=O)-) is bonded to a "di-C₁₋₁₈ hydrocarbylamino group".

The "di-C₁₋₁₈ hydrocarbylaminocarbonyl group" is, for example, but not limited to, a "di-C₁₋₁₈ alkylamino group", such as a dimethylaminocarbonyl group, a diethylaminocarbonyl group, a di-n-propylaminocarbonyl group, a diisopropylaminocarbonyl group, a di-n-butylaminocarbonyl group, a diisobutylaminocarbonyl group, a di-t-butylaminocarbonyl group, a di-n-pentylaminocarbonyl group, a di-n-hexylaminocarbonyl group, an N-ethyl-N-methylaminocarbonyl group, an N-methyl-N-n-propylaminocarbonyl group, an N-isopropyl-N-methylaminocarbonyl group, an N-n-butyl-N-methylaminocarbonyl group, an N-isobutyl-N-methylaminocarbonyl group, an N-t-butyl-N-methylaminocarbonyl group, an N-methyl-N-n-pentylaminocarbonyl group, an N-n-hexyl-N-methylaminocarbonyl group, an N-ethyl-N-n-propylaminocarbonyl group, an N-ethyl-N-isopropylaminocarbonyl group, an N-n-butyl-N-ethylaminocarbonyl group, an N-ethyl-N-isobutylaminocarbonyl group, an N-t-butyl-N-ethylaminocarbonyl group, an N-ethyl-N-n-pentylaminocarbonyl group, or an N-ethyl-N-n-hexylaminocarbonyl group; a "di-C₃₋₁₈ alicyclic aminocarbonyl group", such as a dicyclopropylaminocarbonyl group, a dicyclobutylaminocarbonyl group, a dicyclopentylaminocarbonyl group, or a dicyclohexylaminocarbonyl group; a "di-C₆₋₁₈ arylaminocarbonyl group", such as a diphenylaminocarbonyl group or a phenylnaphthylaminocarbonyl group; or the like.

The term "C₁₋₁₈ hydrocarbylcarbonylamino group", as used herein, refers to a group in which an amino group is bonded to the "C₁₋₁₈ hydrocarbylcarbonyl group".

The "C₁₋₁₈ hydrocarbylcarbonylamino group" is, for example, but not limited to, a "C₁₋₁₈ alkyl carbonylamino group", such as a methyl carbonylamino group, an ethyl carbonylamino group, a n-propyl carbonylamino group, an i-propyl carbonylamino group, a n-butyl carbonylamino group, an i-butyl carbonylamino group, a sec-butyl carbonylamino group, a t-butyl carbonylamino group, a n-pentyl carbonylamino group, an i-pentyl carbonylamino group, or a n-hexyl carbonylamino group; a "C₃₋₁₈ alicyclic carbonylamino group", such as a cyclopropyl carbonylamino group, a cyclobutyl carbonylamino group, a cyclopentyl carbonylamino group, or a cyclohexyl carbonylamino group; a "C₆₋₁₈ aryl carbonylamino group", such as a phenyl carbonylamino group, a naphthyl carbonylamino group, an acenaphthyl carbonylamino group, a phenanthrenyl carbonylamino group, or an anthracenyl carbonyl amino group; or the like.

The term "C₁₋₁₈ hydrocarbylaminocarbonyloxy group", as used herein, refers to a group in which an oxygen atom (-O-) is bonded to the "C₁₋₁₈ hydrocarbylaminocarbonyl group".

The "C₁₋₁₈ hydrocarbylaminocarbonyloxy group" is, for example, but not limited to, a "C₁₋₁₈ alkylaminocarbonyloxy group", such as a methylaminocarbonyloxy group, an ethylaminocarbonyloxy group, or a n-propylaminocarbonyloxy group; a "C₃₋₁₈ alicyclic aminocarbonyloxy group", such as a cyclopropylaminocarbonyloxy group or a cyclohexylaminocarbonyloxy group; a "C₆₋₁₈ arylaminocarbonyloxy group", such as a phenylaminocarbonyloxy group or a 1-naphthylaminocarbonyloxy group; or the like.

The term "di-C₁₋₁₈ hydrocarbylaminocarbonyloxy group", as used herein, refers to a group in which an oxygen atom (-O-) is bonded to the "di-C₁₋₁₈ hydrocarbylaminocarbonyl group".

The "di-C₁₋₁₈ hydrocarbylaminocarbonyloxy group" is, for example, but not limited to, a "di-C₁₋₁₈ alkylaminocarbonyloxy group", such as a dimethylaminocarbonyloxy group, a diethylaminocarbonyloxy group, or a di-n-propylaminocarbonyloxy group; or the like.

The term "C₁₋₁₈ hydrocarbylaminocarbonylamino group", as used herein, refers to a group in which the "C₁₋₁₈ hydrocarbylaminocarbonyl group" is bonded to an amino group.

The "C₁₋₁₈ hydrocarbylaminocarbonylamino group" is, for example, but not limited to, a "C₁₋₁₈ alkylaminocarbonylamino group", such as a methylaminocarbonylamino group, an ethylaminocarbonyloxy group, or a n-propylaminocarbonylamino group; a "C₃₋₁₈ alicyclic aminocarbonylamino group", such as a cyclopropylaminocarbonylamino group or a cyclohexylaminocarbonylamino group; a "C₆₋₁₈ arylaminocarbonylamino group", such as a phenylaminocarbonylamino group or a 1-naphthylaminocarbonylamino group; or the like.

The term "di-C₁₋₁₈ hydrocarbylaminocarbonylamino group", as used herein, refers to a group in which a "di-C₁₋₁₈ hydrocarbylaminocarbonyl group" is bonded to an amino group.

The "di-C₁₋₁₈ hydrocarbylaminocarbonylamino group" is, for example, but not limited to, a "di-C₁₋₁₈ alkylaminocarbonylamino group", such as a dimethylaminocarbonylamino group, a diethylaminocarbonylamino group, or a di-n-propylaminocarbonylamino group; or the like.

The term "C₁₋₁₈ hydrocarbyloxycarbonylamino group", as used herein, refers to a group in which the "C₁₋₁₈ hydrocarbyloxycarbonyl group" is bonded to an amino group.

The "C₁₋₁₈ hydrocarbyloxycarbonylamino group" is, for example, but not limited to, a "C₁₋₁₈ alkoxycarbonylamino group", such as a methoxycarbonylamino group, an ethoxycarbonylamino group, a n-propoxycarbonylamino group, an i-propoxycarbonylamino group, a n-butoxycarbonylamino group, or a t-butoxycarbonylamino group; a "C₃₋₁₈ alicyclic oxycarbonylamino group", such as a cyclopropyloxycarbonylamino group or a cyclohexyloxycarbonylamino group; a "C₆₋₁₈ aryloxycarbonylamino group", such as a phenyloxycarbonylamino group or a 1-naphthyloxycarbonylamino group; or the like.

The term "C₁₋₁₈ hydrocarbylthio group", as used herein, refers to a group in which a sulfur atom (-S-) is bonded to the "C₁₋₁₈ hydrocarbyl group".

The "C₁₋₁₈ hydrocarbylthio group" is, for example, but not limited to, a "C₁₋₁₈ alkylthio group", such as a methylthio group, an ethylthio group, a n-propylthio group, an i-propylthio group, a n-butylthio group, an i-butylthio group, a t-butylthio group, a n-pentylthio group, or a n-hexylthio group; a "C₃₋₁₈ alicyclic thio group", such as a cyclopropylthio group, a cyclobutylthio group, a cyclopentylthio group, a cyclohexylthio group, a 2-methylcyclopentylthio group, a 3-methylcyclopentylthio group, a 2-methylcyclohexylthio group, a 3-methylcyclohexylthio group, or a 4-methylcyclohexylthio group; a "C₆₋₁₈ arylthio group", such as a phenylthio group, a 1-naphthylthio group, a 2-naphthylthio group, an acenaphthylthio group, a phenanthrenylthio group, or an anthracenylthio group; or the like.

The term "C₁₋₁₈ hydrocarbylsulfinyl group", as used herein, refers to a group in which a sulfinyl group (-S(=O)-) is bonded to the "C₁₋₁₈ hydrocarbyl group".

The "C₁₋₁₈ hydrocarbylsulfinyl group" is, for example, but not limited to, a "C₁₋₁₈ alkylsulfinyl group", such as a methylsulfinyl group, an ethylsulfinyl group, a n-propylsulfinyl group, an i-propylsulfinyl group, a n-butylsulfinyl group, a t-butylsulfinyl group, a pentylsulfinyl group, or a hexylsulfinyl group; a "C₃₋₁₈ alicyclic sulfinyl group", such as a cyclopropylsulfinyl group, a cyclobutylsulfinyl group, a cyclopentylsulfinyl group, a cyclohexylsulfinyl group, a 2-methylcyclopentylsulfinyl group, a 3-methylcyclopentylsulfinyl group, a 2-methylcyclohexylsulfinyl group, a 3-methylcyclohexylsulfinyl group, or a 4-methylcyclohexylsulfinyl group; a "C₆₋₁₈ arylsulfinyl group", such as a phenylsulfinyl group, a naphthylsulfinyl group, an acenaphthylsulfinyl group, a phenanthrenylsulfinyl group, or an anthracenylsulfinyl group; or the like.

The term "C₁₋₁₈ hydrocarbylsulfonyl group", as used herein, refers to a group in which a sulfonyl group (-SO₂-) is bonded to the "C₁₋₁₈ hydrocarbyl group".

The "C₁₋₁₈ hydrocarbylsulfonyl group" is, for example, but not limited to, a "C₁₋₁₈ alkylsulfonyl group", such as a methylsulfonyl group, an ethylsulfonyl group, a n-propylsulfonyl group, an i-propylsulfonyl group, a n-butylsulfonyl group, a t-butylsulfonyl group, or a pentylsulfonyl group; a "C₃₋₁₈ alicyclic sulfonyl group", such as a cyclopropylsulfonyl group, a cyclobutylsulfonyl group, a cyclopentylsulfonyl group, a cyclohexylsulfonyl group, a 2-methylcyclopentylsulfonyl group, a 3-methylcyclopentylsulfonyl group, a 2-methylcyclohexylsulfonyl group, a 3-methylcyclohexylsulfonyl group, or a 4-methylcyclohexyl group; a "C₆₋₁₈ arylsulfonyl group", such as a phenylsulfonyl group, a naphthylsulfonyl group, an acenaphthylsulfonyl group, a phenanthrenylsulfonyl group, or an anthracenylsulfonyl group; or the like.

The term "acid-dissociable group", as used herein, refers to a group that substitutes a hydrogen atom of a carboxy group or a hydroxy group (including a phenolic hydroxy group or the like) and is dissociated by the action of an acid.

The term "acid-dissociable group" is, for example, but not limited to, a t-butyl group, a t-amyl group, a 1,1-dimethylpropyl group, a 1-methyl-1-cyclopentyl group, a 1-ethyl-1-cyclopentyl group, a 1-methyl-1-cyclohexyl group, a 1-ethyl-1-cyclohexyl group, a 2-methyl-2-adamantyl group, a 2-ethyl-2-adamantyl group, a 1-(1-methoxy-2-methylpropan-2-yl)cyclopentyl group, a 1-(1-ethoxy-2-methylpropan-2-yl)cyclopentyl group, or the like.

The term "a hydroxy group or a carboxy group having a protective group", as used herein, refers to a hydroxy group or carboxy group in which the hydroxy group (including a phenolic hydroxy group) or the carboxy group is protected by an ether protective group, a silyl ether protective group, an acyl protective group, an aminocarbonyl protective group, or the like.

The ether protective group is, for example, but not limited to, a methyl group, a benzyl group, a p-methoxybenzyl group, a t-butyl group, a triphenylmethyl group, a p-methoxyphenyldiphenylmethyl group, di(p-methoxyphenyl)phenylmethyl group, or the like.

The silyl ether protective group is, for example, but not limited to, a t-butyldimethylsilyl group (TBS), a triisopropylsilyl group (TIPS), a trimethylsilyl group (TMS), a triethylsilyl group (TES), a t-butyldiphenylsilyl group (TBDPS), or the like.

The acyl protective group is, for example, but not limited to, an acetyl group, a pivaloyl group, a benzoyl group, or the like.

The aminocarbonyl protective group is, for example, but not limited to, a dimethylaminocarbonyl group, a diethylaminocarbonyl group, a diisopropylaminocarbonyl group, an N-phenyl-N-methyl-aminocarbonyl group, or the like.

The phrase "optionally substituted", as used herein, is not particularly limited, provided that it is chemically acceptable and has the advantages of the present invention.

The "substituent" is, for example, (1) a halogen atom, (2) a hydroxy group, (3) a thiol group, (4) a nitro group, (5) a cyano group, (6) a carboxy group, (7) an amino group, (8) a sulfo group, (9) a group in which a hydrogen atom of a carboxy group or a hydroxy group is substituted by an acid-dissociable group, (10) a hydroxy group or a carboxy group having a protective group, or (11) a C₁₋₈ hydrocarbyl group, a C₁₋₈ hydrocarbyloxy group, a C₁₋₈ hydrocarbylcarbonyl group, a C₁₋₈ hydrocarbylcarbonyloxy group, a C₁₋₈ hydrocarbyloxycarbonyl group, a C₁₋₈ hydrocarbyloxycarbonyloxy group, a C₁₋₈ hydrocarbylamino group, a di-C₁₋₈ hydrocarbylamino group, a C₁₋₈ hydrocarbylaminocarbonyl group, a di-C₁₋₈ hydrocarbylaminocarbonyl group, a C₁₋₈ hydrocarbylcarbonylamino group, a C₁₋₈ hydrocarbylaminocarbonyloxy group, a di-C₁₋₈ hydrocarbylaminocarbonyloxy group, a C₁₋₈ hydrocarbylaminocarbonylamino group, a di-C₁₋₈ hydrocarbylaminocarbonylamino group, a C₁₋₈ hydrocarbyloxycarbonylamino group, a C₁₋₈ hydrocarbylthio group, a C₁₋₈ hydrocarbylsulfinyl group, a C₁₋₈ hydrocarbylsulfonyl group, in which at least part of their hydrogen atoms may be substituted by (1) to (10) and a divalent carbon atom at any position except the end(s) of the substituent may be replaced by -O-, -C(=O)-, -C(=O)O-, -OCO-, -CONH-, -NHCO-, - NH(C=O)O-, -S-, or -SO₂- (provided that adjacent divalent carbon atoms are not replaced at the same time), or the like.

### [1-1. (A) Resin Component Whose Solubility in Developer Changes by Action of Acid]

The resist composition according to the present embodiment contains (A) a resin component whose solubility in a developer changes by the action of an acid. The component (A) can be a known and commonly used component and is not particularly limited. From the perspective of changing the solubility in a developer by the action of an acid, the component (A) preferably contains an acid-dissociable group.

The acid-dissociable group may be contained in the component (A) as a structural unit (a1) having an acid-dissociable group. The component (A) can contain an acid-dissociable group, for example, by copolymerizing the structural unit (a1) having an acid-dissociable group with another optional structural unit (by any polymerization, such as alternating copolymerization, random copolymerization, block copolymerization, or graft copolymerization).

The component (A) may contain, as the optional structural unit, a structural unit (a2) having a phenolic hydroxy group, a structural unit (a3) having a lactone-containing alicyclic group, a structural unit (a4) having a polar group-containing hydrocarbyl group, and another structural unit.

The "acid-dissociable group", the "structural unit (a1) having an acid-dissociable group", the "structural unit (a2) having a phenolic hydroxy group", the "structural unit (a3) having a - containing alicyclic group", the "structural unit (a4) having a polar group-containing hydrocarbyl group", and the "another structural unit" will be described below.

### [1-1-1. Acid-Dissociable Group]

The acid-dissociable group is not particularly limited and may be a known and commonly used acid-dissociable group. The acid-dissociable group is, for example, an acid-dissociable group G represented by the following formula (g-1) or (g-2) and may be a group that substitutes a hydrogen atom of a carboxy group, a hydroxy group (including a phenolic hydroxy group), or the like and is dissociated by the action of an acid.

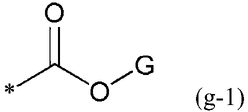

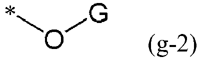

The acid-dissociable group G is not particularly limited, provided that it can be dissociated by the action of an acid, and a known and commonly used group can be used. The acid-dissociable group G in the present embodiment may be, for example, a group in which carbon bonded to a carboxy group or a hydroxy group is tertiary carbon, such as an acid-dissociable group represented by the following formula (g-3).

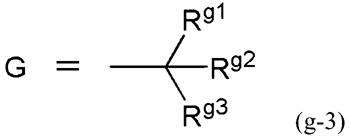

In the general formula (g-3), "R^{g1}" denotes an optionally substituted C₁₋₁₂ hydrocarbyl group in which a divalent carbon atom at any position except the end(s) thereof may be replaced by -O-, -C(=O)-, -C(=O)O-, -OCO-, -CONH-, NHCO-, -S-, or -SO₂- (provided that adjacent divalent carbon atoms are not replaced at the same time).

"R^{g2}" and "R^{g3}" each independently denote an optionally substituted C₁₋₁₂ hydrocarbyl group in which a divalent carbon atom at any position except the end(s) thereof may be replaced by -O-, -C(=O)-, -C(=O)O-, -OCO-, -CONH-, NHCO-, -S-, or -SO₂- (provided that adjacent divalent carbon atoms are not replaced at the same time), or R^{g2} and R^{g3} may be combined to constitute an optionally substituted C₃₋₁₈ alicyclic group or a 3- to 18-membered non-aromatic heterocyclic group.

In the general formula (g-3), from the perspective of improving dissociability by the action of an acid, R^{g1} preferably denotes a C₁₋₆ alkyl group, a C₂₋₁₂ alkenyl group, a C₃₋₁₈ alicyclic group, a C₂₋₁₈ aryl group, or a C₇₋₁₂ aralkyl group, in which part of hydrogen atoms may be substituted by a substituent and a divalent carbon atom at any position except the end(s) thereof may be replaced by -O-, -C(=O)-, -C(=O)O-, -OCO-, -CONH-, NHCO-, -S-, or -SO₂-(provided that adjacent divalent carbon atoms are not replaced at the same time), more preferably a C₁₋₆ alkyl group, a C₂₋₁₂ alkenyl group, a C₃₋₁₈ alicyclic group, or a C₂₋₁₈ aryl group, in which part of hydrogen atoms may be substituted by a substituent and a divalent carbon atom at any position except the end(s) thereof may be replaced by -O-, -C(=O)-, -C(=O)O-, -OCO-, -CONH-, NHCO-, -S-, or -SO₂- (provided that adjacent divalent carbon atoms are not replaced at the same time).

Specific examples include, but are not limited to, a C₁₋₆ alkyl group, such as a methyl group, an ethyl group, or a propyl group; a C₂₋₁₂ alkenyl group, such as a vinyl group, an allyl group, a 1-propenyl group, a 1-butenyl group, or a pentenyl group; a C₃₋₁₈ alicyclic group, such as a cyclopropyl group, a cyclobutyl group, a cyclopentyl group, a cyclohexyl group, a cyclopent-1-en-1-yl group, a 2-methylcyclopent-1-en-1-yl group, a cyclohex-1-en-1-yl group, a 4-methylcyclohex-1-en-1-yl group, or a cyclopentylidenemethyl group; and a C₂₋₁₈ aryl group, such as a phenyl group, a tolyl group, a xylyl group, or a mesityl group.

Furthermore, in the general formula (g-3), from the perspective of improving the dissociability by the action of an acid, R^{g2} and R^{g3} are preferably combined to constitute an optionally substituted C₃₋₁₈ alicyclic group or a 3- to 18-membered non-aromatic heterocyclic group.

Specific examples thereof include, but are not particularly limited to, a C₃₋₁₈ alicyclic group having a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, and a tricyclodecene skeleton.

The acid-dissociable group G is, for example, but not limited to, a 1-methylcyclopentyl group, a 1-ethylcyclopentyl group, a 1-phenylcyclopentyl group, a 1-tolylcyclopentyl group, a 1-methylcyclohexyl group, a 1-ethylcyclohexyl group, a 1-phenylcyclohexyl group, a 1-tolylcyclohexyl group, a 1-(naphthalen-2-yl)cyclohexyl group, a 1-(1-methoxy-2-methylpropan-2-yl)cyclopentyl group, a 1-(1-ethoxy-2-methylpropan-2-yl)cyclopentyl group, a 2-methyladamantan-2-yl group, a 2-ethyladamantan-2-yl group, a 2-phenyladamantan-2-yl group, or the like.

### [1-1-2. Structural Unit (a1) Having Acid-Dissociable Group]

The structural unit (a1) having an acid-dissociable group is not particularly limited and may be a known and commonly used structural unit. (a1) is, for example, a structural unit represented by the following formula (a1-1), (a1-2), or the like.

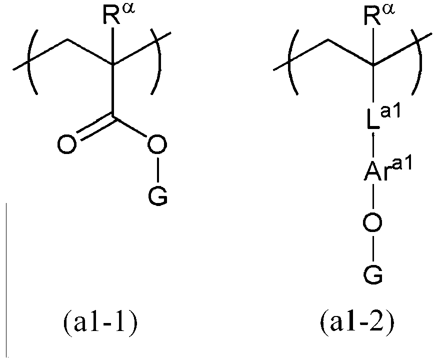

In the formulae (a1-1) and (a1-2), "R^{α}" denotes a hydrogen atom, a methyl group, or a trifluoromethyl group, and "G" denotes an acid-dissociable group G.

In the formula (a1-2), "L^{a1}" denotes a single bond, -O-, -C(=O)-, -C(=O)O-, -OCO-, - CONH-, NHCO-, -S-, or -SO₂-, "Ar^{a1}" denotes an optionally substituted C₆₋₁₈ arylene group, and "-O-G" means that "-O-G" is bonded to one of the two ends of Ar^{a1},

The optionally substituted C₆₋₁₈ arylene group is, for example, but not limited to, a 1,4-phenylene group, a 1,3-phenylene group, a 1,2-phenylene group, a 1,4-naphthylene group, a 1,5-naphthylene group, a 1,8-naphthylene group, a 4,4'-biphenylene group, an anthracenediyl group, a phenanthrenediyl group, a naphthacenediyl group, a pyrenediyl group, a perylenediyl group, or a chrysenediyl group, and at least one hydrogen atom may be substituted by a substituent.

The structural unit (a1-1) having an acid-dissociable group is, for example, but not limited to, a structural unit represented by the following formula, or the like. In the following formula, "R^{α}" denotes a hydrogen atom, a methyl group, or a trifluoromethyl group.

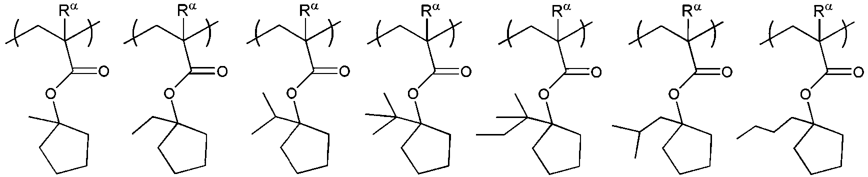

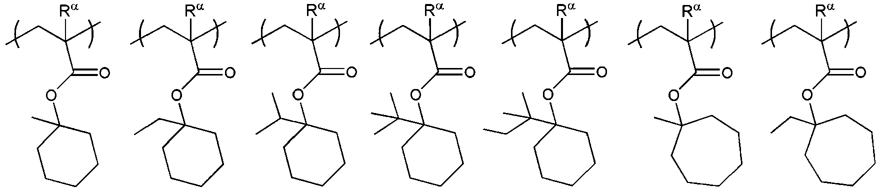

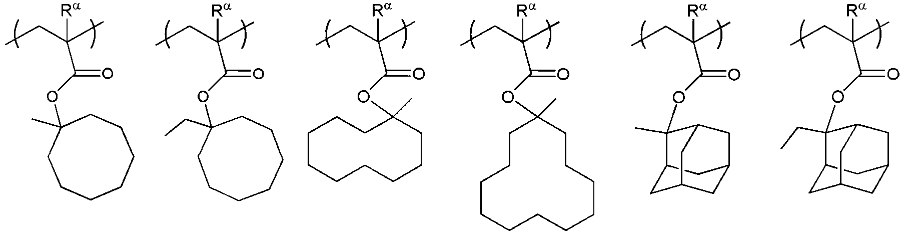

The structural unit (a1-2) having an acid-dissociable group is, for example, but not limited to, a structural unit represented by the following formula, or the like. In the following formula, "R^{α}" denotes a hydrogen atom, a methyl group, or a trifluoromethyl group.

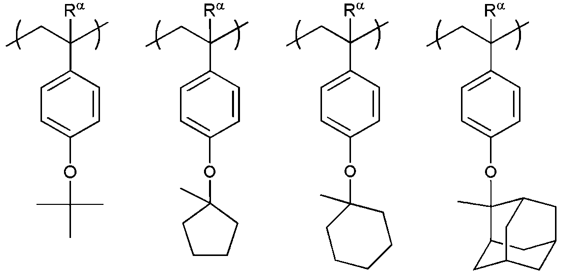

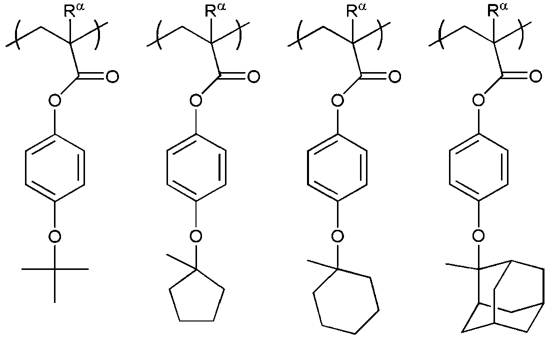

The lower limit of the "structural unit (a1) having an acid-dissociable group" content with respect to the total structural unit constituting the component (A) is preferably 10% by mole, more preferably 20% by mole, still more preferably 25% by mole, particularly preferably 30% by mole. The upper limit of the content is preferably 90% by mole, more preferably 80% by mole, still more preferably 75% by mole, particularly preferably 70% by mole. An amount of the structural unit (a1) having an acid-dissociable group within such a range can result in a sufficient dissolution contrast in a developer between a portion of the component (A) treated with an acid and a portion not treated with the acid.

### [1-1-3. Structural Unit (a2) Having Phenolic Hydroxy Group]

The structural unit (a2) having a phenolic hydroxy group is not particularly limited and may be a known and commonly used structural unit. (a2) is, for example, a structural unit represented by the following formula (a2-1) or the like.

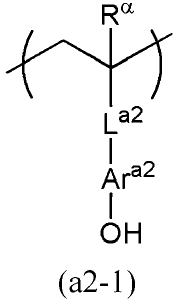

In the formula (a2-1), "R^{α}" denotes a hydrogen atom, a methyl group, or a trifluoromethyl group, "L^{a2}" denotes a single bond, -O-, -C(=O)-, -C(=O)O-, -OCO-, -CONH-, NHCO-, -S-, or - SO₂-, "Ar^{a2}" denotes an optionally substituted C₆₋₁₈ arylene group, and -OH" means that a hydroxy group is bonded to one of the two ends of Ar^{a2}. Like "Ar^{a1}", "Ar^{a2}" is, for example, but not limited to, a C₆₋₁₈ arylene group, and one or more hydrogen atoms of the C₆₋₁₈ arylene group may be substituted by a substituent.

The structural unit (a2-1) having a phenolic hydroxy group is, for example, but not limited to, a structural unit represented by the following formula, or the like. In the following formula, "R^{α}" denotes a hydrogen atom, a methyl group, or a trifluoromethyl group.

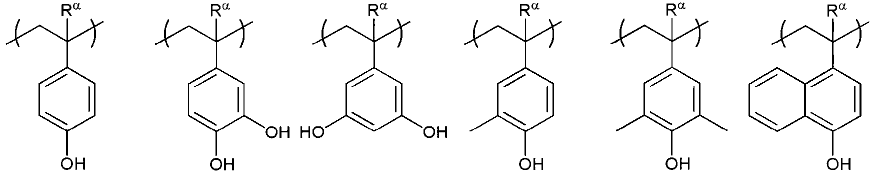

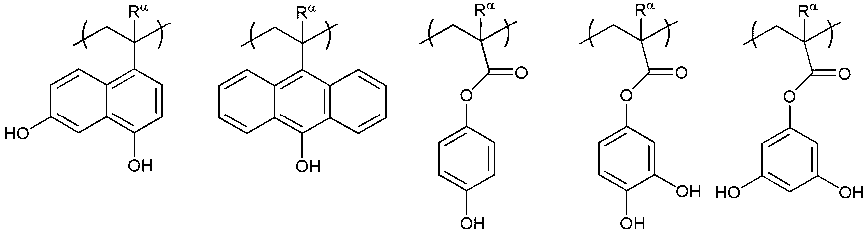

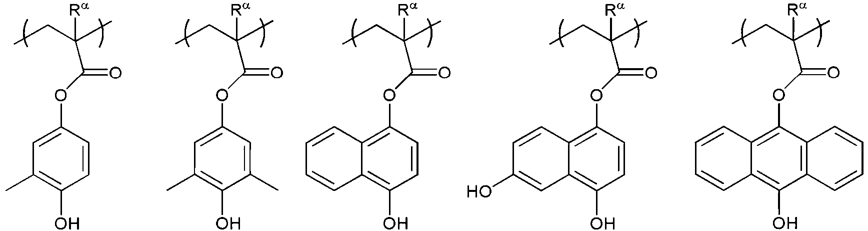

The lower limit of the "structural unit (a2) having a phenolic hydroxy group" content with respect to the total structural unit constituting the component (A) is preferably 5% by mole, more preferably 10% by mole, still more preferably 20% by mole, particularly preferably 30% by mole. The upper limit of the content is preferably 90% by mole, more preferably 80% by mole, still more preferably 70% by mole, particularly preferably 60% by mole. An amount of the structural unit (a2) having a phenolic hydroxy group within such a range can result in the component (A) with higher sensitive to irradiation.

### [1-1-4. Structural Unit (a3) Having Lactone-Containing Alicyclic Group]

The structural unit (a3) having a lactone-containing alicyclic group is any structural unit having an alicyclic group containing a cyclic ester, that is, a lactone (-C(=O)-O-) and can be a known and commonly used structural unit. The lactone-containing alicyclic group may be monocyclic or polycyclic. The adhesiveness of a resist to a substrate can be enhanced by containing (a3).

(a3) is, for example, a structural unit represented by the following formula (a3-1) or the like.

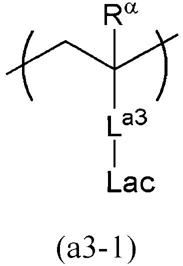

In the formula (a3-1), "R^{α}" denotes a hydrogen atom, a methyl group, or a trifluoromethyl group, "L^{a3}" denotes a single bond, -O-, -C(=O)-, -C(=O)O-, -OCO-, -CONH-, NHCO-, -S-, or - SO₂-, "Lac" denotes a lactone-containing alicyclic group represented by the following formulae (1-1) to (1-4), any hydrogen atom on the lactone-containing alicyclic group may be replaced by a bond to L^{a3}, and one or more other hydrogen atoms may be substituted by a substituent.

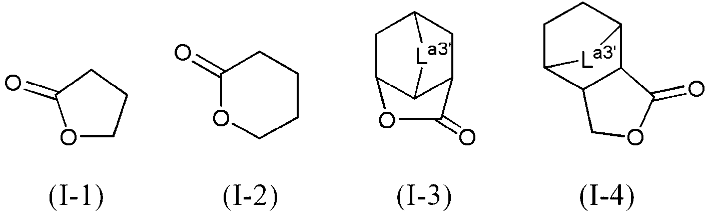

In the formulae (1-3) and (1-4), "L^{a3'}" denotes -O-, -S-, or an alkylene group that may contain -O- or -S-C₁₋₃.

The structural unit (a3-1) having a lactone-containing alicyclic group is, for example, but not limited to, a structural unit represented by the following formula, or the like. In the following formula, "R^{α}" denotes a hydrogen atom, a methyl group, or a trifluoromethyl group.

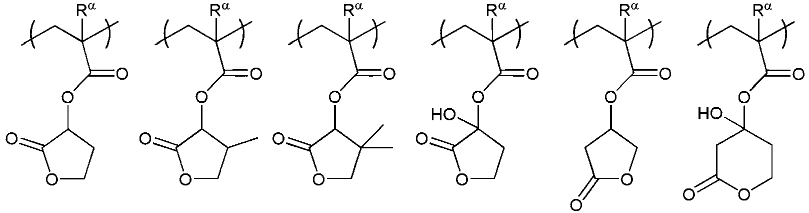

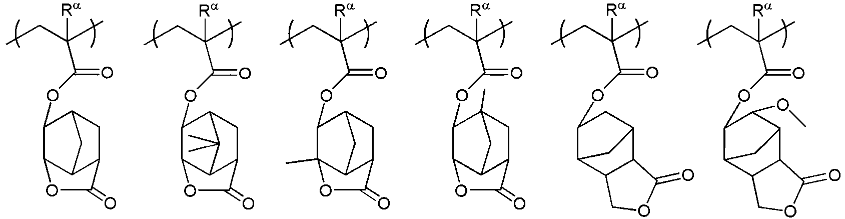

The lower limit of the "structural unit (a3) having a lactone-containing alicyclic group" content with respect to the total structural unit constituting the component (A) is preferably 5% by mole, more preferably 10% by mole, still more preferably 20% by mole, particularly preferably 30% by mole. The upper limit of the content is preferably 60% by mole, more preferably 55% by mole, still more preferably 50% by mole. When the amount of the structural unit (a3) having a lactone-containing alicyclic group is within such a range, a good balance can be achieved with another constitutional unit while enhancing the adhesiveness of a resist to a substrate.

### [1-1-5. Structural Unit (a4) Having Polar Group-Containing Hydrocarbyl Group]

The structural unit (a4) having a polar group-containing hydrocarbyl group is not particularly limited and may be a known and commonly used structural unit. By containing (a4), the acid diffusion length can be appropriately adjusted while maintaining the hydrophilicity of the polymer (A).

The polar group of (a4) may be a hydroxy group, a cyano group, a carboxy group, a haloalkyl group, or the like.

The hydrocarbyl group is preferably a C₁₋₁₈ hydrocarbyl group in which one or more hydrogen atoms are substituted by a polar group and in which one or more hydrogen atoms may also be substituted by a substituent, more preferably a C₃₋₁₈ alicyclic group in which one or more hydrogen atoms are substituted by a polar group and in which one or more hydrogen atoms may also be substituted by a substituent, still more preferably an adamantyl group, a norbornyl group, an isobornyl group, a cyclopentyl group, a cyclohexyl group, a cycloheptyl group, a cyclooctyl group, or a tricyclodecyl group in which one or more hydrogen atoms are substituted by a polar group and in which one or more hydrogen atoms may also be substituted by a substituent.

(a4) is, for example, a structural unit represented by the following formula (a4-1) or the like.

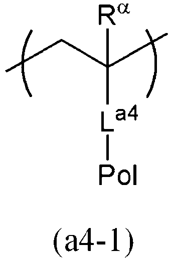

In the formula (a4-1), "R^{α}" denotes a hydrogen atom, a methyl group, or a trifluoromethyl group, "L^{a4}" denotes a single bond, -O-, -C(=O)-, -C(=O)O-, -OCO-, -CONH-, NHCO-, -S-, or - SO₂-, and "Pol" denotes a C₁₋₁₈ hydrocarbyl group in which one or more hydrogen atoms are substituted by a polar group and in which one or more hydrogen atoms may also be substituted by a substituent.

The lower limit of the "structural unit (a4) having a polar group-containing hydrocarbyl group" content with respect to the total structural unit constituting the component (A) is preferably 1% by mole, more preferably 2% by mole, still more preferably 5% by mole. The upper limit of the content is preferably 40% by mole, more preferably 35% by mole, still more preferably 30% by mole. When the amount of the structural unit (a4) having a polar group-containing hydrocarbyl group is within such a range, the acid diffusion length can be appropriately adjusted while maintaining hydrophilicity, and a good balance can be achieved with another constitutional unit.

### [1-1-6. Another Structural Unit]

The component (A) may have another optional structural unit other than (a2) to (a4). The optional structural unit is, for example, but not limited to, a structural unit having an alicyclic group containing a lactam, sulfone, sultone, carbonate, or another skeleton, a structural unit having styrene or a styrene derivative, or the like.

### [1-1-7. Component (A)]

When the component (A) contains both the "structural unit (a1) having an acid-dissociable group" and the "structural unit (a2) having a phenolic hydroxy group", the mole ratio of the structural unit (a1) to the structural unit (a2) preferably ranges from 2:8 to 8:2, more preferably 3:7 to 7:3, still more preferably 4:6 to 6:4.

When the component (A) contains all of the "structural unit (a1) having an acid-dissociable group", the "structural unit (a3) having a lactone-containing alicyclic group", and the "structural unit (a4) having a polar group-containing hydrocarbyl group", a mole ratio of the structural unit (a1):the structural unit (a3):the structural unit (a4) is preferably 2 to 6:2 to 6:1 to 3, more preferably 3 to 5:3 to 5:1 to 3, still more preferably 3 to 5:3 to 5:2.

The method for synthesizing the component (A) is, for example, but not limited to, a method of dissolving monomers from which the respective structural units are derived in a polymerization solvent and adding a radical polymerization initiator, such as azobisisobutyronitrile (AIBN) or dimethyl azobisisobutyrate, thereto to perform polymerization.

The weight-average molecular weight (Mw) (in terms of polystyrene equivalent determined by gel permeation chromatography (GPC)) of the component (A) is not particularly limited, and the lower limit thereof is preferably 1000, more preferably 2000, still more preferably 3000. The upper limit of the Mw is preferably 50,000, more preferably 30,000, still more preferably 20,000. When the Mw of the component (A) is equal to or higher than the lower limit, the etching characteristics and the cross-sectional shape of a resist pattern can be improved, and when the Mw is equal to or lower than the upper limit, the solubility of the component (A) can be maintained.

The dispersity (Mw/Mn) of the component (A) is, for example, but not limited to, preferably 1.0 to 4.0, more preferably 1.0 to 3.0, still more preferably 1.0 to 2.0. Mn means a number-average molecular weight. When the dispersity of the component (A) is within such a range and the molecular weight distribution is narrowed, the reactivity of the resist composition can be made uniform.

The component (A) content of the total solid component in the resist composition preferably ranges from 1% to 80% by mass, more preferably 5% to 75% by mass, still more preferably 10% to 70% by mass. The "total solid component" refers to components other than the solvent of the resist composition.

### [1-2. (B) Polyacid Salt]

The resist composition according to the present embodiment contains (B) a polyacid salt. The component (B) can be a known and commonly used component and is not particularly limited. The polyacid salt (also referred to as a polyoxometalate) as the component (B) can function as both an acid generator and an acid diffusion inhibitor, and the range in which an acid is generated and diffused by exposure to light can be appropriately finely adjusted according to the exposure level or the like. Furthermore, the acid strength, the absorbency for an exposure light source, and the like can be adjusted by the combination of an anion moiety and a cation moiety of the polyacid salt.

The polyacid is an anionic metal oxide cluster represented by the general formula [MₓO_{y}]ⁿ⁻ (wherein x, y, and n all denote natural numbers). The metal atom M constituting the polyacid is referred to as a polyatom and is, for example, Mo (hexavalent or pentavalent), W (hexavalent or pentavalent), V (pentavalent), Nb (pentavalent), Ta (pentavalent), or the like. The polyacid can be broadly divided into an isopolyacid composed of the polyatom M and an oxoacid, and a heteropolyacid ([X_{w}MₓO_{y}]ⁿ⁻ (wherein w, x, y, and n all denote natural numbers)) containing a different type of atom X (for example, P⁵⁺, Si⁴⁺, Ge⁴⁺, B³⁺, or the like as a heteroatom X) in addition to the polyatom M and oxygen.

The polyacid salt is composed of an anion moiety of an isopolyacid or a heteropolyacid and a counter cation thereof. The anion moiety and the cation moiety of the polyacid salt will be separately described below.

### [1-2-1. Anion Moiety of Polyacid Salt]

The anion moiety of the polyacid salt is composed of an isopolyacid anion or a heteropolyacid anion.

The isopolyacid anion is, for example, an isopolyoxomolybdate anion, an isopolyoxotungstate anion, an isopolyoxovanadate anion, an isopolyoxoniobate anion, an isopolyoxotantalate anion, or the like.

The isopolyoxomolybdate anion is, for example, [MoO₄]²⁻, [Mo₇O₂₄]⁶⁻, [Mo₈O₂₆]⁴⁻, or the like. The isopolyoxotungstate anion is, for example, [W₄O₁₃]²⁻, [W₅O₁₆]²⁻, [W₆O₁₉]²⁻, [W₇O₂₂]²⁻, [W₇O₂₄]⁶⁻, [H_{z}W₁₂O₄₀]^{-(8-z)} (wherein z denotes an integer in the range of 1 to 4), [W₁₀O₃₂]⁴⁻, [H₄W₁₁O₃₈]⁶⁻, [H₇W₁₁O₄₀]⁷⁻, [HW₅O₁₉]⁷⁻, [H₃W₁₁O₂₂]⁵⁻, or the like. The isopolyoxovanadate anion is, for example, [V₄O₁₂]⁴⁻, [V₁₀O₂₈]⁶⁻, or the like, the isopolyoxoniobate anion is, for example, [Nb₆O₁₉]⁸⁻, [Nb₁₀O₂₈]⁶⁻, or the like, and the isopolyoxotantalate anion is, for example, [Ta₆O₁₉]⁸⁻, Ta₈O₂₁]²⁻, or the like.

The isopolyoxomolybdate anion, the isopolyoxotungstate anion, the isopolyoxovanadate anion, the isopolyoxoniobate anion, and the isopolyoxotantalate anion include various isomers and the like.

The heteropolyacid anion is, for example, a heteropolyoxomolybdate anion, a heteropolyoxotungstate anion, a heteropolyoxovanadate anion, a heteropolyoxoniobate anion, a heteropolyoxotantalate anion, or the like.

The heteropolyoxomolybdate anion is, for example, a phosphomolybdate anion, a silicomolybdate anion, a boromolybdate anion, a phosphotungstomolybdate anion, a cobalt molybdate anion, an arsenic molybdate anion, a germanium molybdate anion, or the like. The heteropolyoxotungstate anion is, for example, a phosphotungstate anion, a silicotungstate anion, a borotungstate anion, a cobalt tungstate anion, an arsenic tungstate anion, a germanium tungstate anion, or the like. The heteropolyoxovanadate anion is, for example, a phosphomolybdovanadate anion, a phosphomolybdotungstomolybdate anion, a boromolybdovanadate anion, a boromolybdotungstovanadate anion, or the like.

The heteropolyoxomolybdate anion, the heteropolyoxotungstate anion, the heteropolyoxovanadate anion, and the like include a Keggin type, a Dawson type, an Anderson type, and deficient species and isomers thereof.

### [1-2-2. Cation Moiety of Polyacid Salt]

The type of the salt of the polyacid salt (isopolyoxometalate or heteropolyoxometalate) may be, but is not limited to, a salt with a proton, an onium cation (for example, an organic onium cation, an organic sulfonium cation, an organic iodonium cation, an organic quaternary ammonium cation, an organic phosphonium cation, or the like), an alkali metal ion, or the like. From the perspective of improving actinic ray sensitivity or radiation sensitivity and changing the solvent solubilities of an exposed portion and an unexposed portion, the type of the salt of the polyacid salt is preferably a salt with an onium cation, more preferably a salt with an organic sulfonium cation, an organic iodonium cation, or an organic quaternary ammonium cation.

### [1-2-2-1. Organic Sulfonium Cation]

The organic sulfonium cation is not particularly limited and may be a known and commonly used organic sulfonium cation. The organic sulfonium cation is, for example, an organic sulfonium cation represented by the formula (b-1).

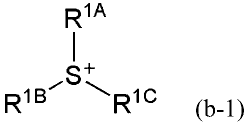

In the formula (b-1), R^{1A}, R^{1B}, and R^{1C} each independently denote a C₁₋₁₈ hydrocarbyl group or a 3- to 18-membered non-aromatic heterocyclic group,
a divalent carbon atom at any position except the end(s) of R^{1A}, R^{1B}, and R^{1C} may be replaced by -O-, -C(=O)-, -C(=O)O-, -OCO-, -CONH-, -NHCO-, -NH(C=O)O-, -S-, or -SO₂-(provided that adjacent divalent carbon atoms are not replaced at the same time),
a hydrogen atom in R^{1A}, R^{1B}, and R^{1C} is, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a group in which a hydrogen atom of a carboxy group or a hydroxy group is substituted by an acid-dissociable group, (k) a hydroxy group or a carboxy group having a protective group, or (l) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of a hydrogen atom may be substituted by (a) to (k), and a divalent carbon atom at any position except the ends of these substituents may be replaced by -O-, -C(=O)-, -C(=O)O-, -OCO-, -CONH-, -NHCO-, -NH(C=O)O-, -S-, or -SO₂-(provided that adjacent divalent carbon atoms are not replaced at the same time); and
any two of R^{1A}, R^{1B}, and R^{1C} may be linked to each other directly by a single bond or via a divalent linking group -O-, -S-, -C(=O)-, -S(=O)-, -S(=O)₂-, -C(=O)O-, or a C₁₋₃ alkylene group to form a ring together with a sulfur atom in the (b-1).

R^{1A}, R^{1B}, and R^{1C} in the formula (b-1) preferably each independently denote an optionally substituted C₂₋₁₈ aryl group. A substituent for the C₂₋₁₈ aryl group is preferably a halogen atom, a haloalkyl group, a hydroxy group, a nitro group, a cyano group, or an optionally substituted C₁₋₁₂ hydrocarbylthio group, more preferably a halogen atom, a C₁₋₄ haloalkyl group, or a nitro group.

Specific examples of the organic sulfonium cation include a dibutyl(pentyl)sulfonium cation, a triethylsulfonium cation, (2-carboxyethyl)dimethylsulfonium cation, a trimethylsulfonium cation, a dimethylphenacylsulfonium cation, a 1-(4-hydroxynaphthalen-1-yl)hexahydrothiopyrylium cation, a dimethylphenylsulfonium cation, a triphenylsulfonium cation, a tris(4-methylphenyl)sulfonium cation, a 4-methoxyphenyldiphenylsulfonium cation, a 4-iodophenyldiphenylsulfonium cation, a tris(4-fluorophenyl)sulfonium cation, a 1-phenylhexahydrothiopyrylium cation, an (ethane-1,2-diylbisoxy)bis(4,1-phenylene)bis(diphenylsulfonium) dication, a (thiodi-4,1-phenylene)bis(diphenylsulfonium) dication, a di(naphthalen-1-yl)(phenyl)sulfonium cation, a phenyl bis(2-(trifluoromethyl)phenyl)sulfonium cation, a mesityl bis(2-(trifluoromethyl)phenyl)sulfonium cation, a bis(3,5-difluorophenyl)(phenyl)sulfonium cation, a tris(3,5-difluorophenyl)sulfonium cation, a (4-(dodecanoyloxy-3,5-dimethylphenyl))diphenylsulfonium cation, a diphenyl(3-(trifluoromethoxy)phenyl)sulfonium cation, a (4-(1-adamantylcarbonyloxy)phenyl)diphenylsulfonium cation, a (4-phenylthiophenyl)diphenylsulfonium cation, a 5-phenyl-5H-thianthren-5-ium cation, a 5-(2,5-dimethylphenyl)thianthren-5-ium cation, a 5-phenyl-5H-dibenzo[b,d]thiophen-5-ium cation a 5-(3-(trifluoromethyl)phenyl)-5H-dibenzo[b,d]thiophen-5-ium cation, a 1-(4-(t-butyl)phenyl)-1H-benzo[b]thiophen-1-ium cation, a methyldiphenylsulfonium cation, a (2-bromoethyl)diphenylsulfonium cation, a (3-chloropropyl)diphenylsulfonium cation, a benzyl(4-hydroxyphenyl)methylsulfonium cation, a (4-hydroxyphenyl)methyl(2-methylbenzyl)sulfonium cation, a 4-hydroxyphenyldimethylsulfonium cation, a diphenyl(methyl)sulfonium cation, a diphenyl(4-(phenylthio)phenyl)sulfonium cation, a (2-bromoethyl)diphenylsulfonium cation, a dimesityl(trifluoromethyl)sulfonium cation, and a tri-p-tolylsulfonium cation.

### [1-2-2-2. Organic Iodonium Cation]

The organic iodonium cation is not particularly limited and may be a known and commonly used organic iodonium cation. The organic iodonium cation is, for example, an organic iodonium cation represented by the formula (b-2).

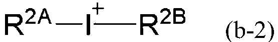

In the formula (b-2), R^{2A} and R^{2B} each independently denote a C₁₋₁₈ hydrocarbyl group or a 3- to 18-membered non-aromatic heterocyclic group,
a divalent carbon atom at any position except the end(s) of R^{2A} and R^{2B} may be replaced by -O-, -C(=O)-, -C(=O)O-, -OCO-, -CONH-, -NHCO-, -NH(C=O)O-, -S-, or -SO₂- (provided that adjacent divalent carbon atoms are not replaced at the same time);
a hydrogen atom in R^{2A} and R^{2B} is, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a group in which a hydrogen atom of a carboxy group or a hydroxy group is substituted by an acid-dissociable group, (k) a hydroxy group or a carboxy group having a protective group, or (l) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, or a C₁₋₁₈ hydrocarbyloxycarbonyloxy group, in which at least part of a hydrogen atom may be substituted by (a) to (k), and a divalent carbon atom at any position except the ends of these substituents may be replaced by -O-, -C(=O)-, - C(=O)O-, -OCO-, -CONH-, -NHCO-, -NH(C=O)O-, -S-, or -SO₂- (provided that adjacent divalent carbon atoms are not replaced at the same time); and
furthermore, R^{2A} and R^{2B} may be linked to each other directly by a single bond or via a divalent linking group -O-, -S-, -C(=O)-, -S(=O)-, -S(=O)₂-, -C(=O)O-, or a C₁₋₃ alkylene group to form a ring together with the iodine atom in the formula (b-2).

R^{2A} and R^{2B} in the formula (b-2) preferably each independently denote an optionally substituted C₂₋₁₈ aryl group. A substituent for the C₂₋₁₈ aryl group is preferably a halogen atom, a haloalkyl group, a hydroxy group, a nitro group, a cyano group, an optionally substituted C₁₋₁₂ hydrocarbyl group, C₁₋₁₂ hydrocarbyloxy group, C₁₋₁₂ hydrocarbylcarbonyl group, C₁₋₁₂ hydrocarbylcarbonyloxy group, C₁₋₁₂ hydrocarbyloxycarbonyl group, or C₁₋₁₂ hydrocarbyloxycarbonyloxy group, preferably a halogen atom, a C₁₋₄ haloalkyl group, a nitro group, a C₁₋₈ hydrocarbyl group, or a C₁₋₈ hydrocarbyloxy group.

Specific examples of the organic iodonium cations include an ethynyl(phenyl)iodonium cation, a bis(pyridine)iodonium cation, a bis(2,4,6-trimethylpyridine)iodonium cation, a diphenyliodonium cation, a bis(4-(t-butyl)phenyl)iodonium cation, a (2-carboxyphenyl)(phenyl)iodonium cation, a (4-nitrophenyl)(phenyl)iodonium cation, a (3-(trifluoromethyl)phenyl)(2,4,6-trimethylphenyl)iodonium cation, a bis(4-fluorophenyl)iodonium cation, a (4-(bromomethyl)phenyl)(2,4,6-trimethoxyphenyl)iodonium cation, a 4-biphenylyl(2,4,6-trimethoxyphenyl)iodonium cation, a bis(2,4,6-trimethylphenyl)iodonium cation, a 4-isopropyl-4'-methyldiphenyliodonium cation, a (4-(trifluoromethyl)phenyl)(2,4,6-trimethylphenyl)iodonium cation, a ((4-trifluoromethyl)phenyl)(2,4,6-trimethoxyphenyl)iodonium cation, a (5-fluoro-2-nitrophenyl)(2,4,6-trimethoxyphenyl)iodonium cation, a (3-bromophenyl)(mesityl)iodonium cation, a bis(4-bromophenyl)iodonium cation, a (3,5-dichlorophenyl)(2,4,6-trimethoxyphenyl)iodonium cation, a (4-methylphenyl)(2,4,6-trimethylphenyl)iodonium cation, a (3-methylphenyl)(2,4,6-trimethylphenyl)iodonium cation, a (2-methylphenyl)(2,4,6-trimethylphenyl)iodonium cation, a phenyl(2,4,6-trimethoxyphenyl)iodonium cation, and the like.

### [1-2-2-3. Organic Quaternary Ammonium Cation]

The organic quaternary ammonium cation is not particularly limited and may be a known and commonly used organic quaternary ammonium cation. The organic quaternary ammonium cation is, for example, an organic quaternary ammonium cation represented by the formula (b-3).

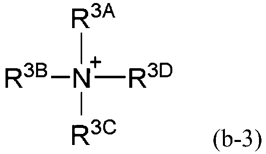

In the formula (b-3), R^{3A}, R^{3B}, R^{3C}, and R^{3D} each independently denote a C₁₋₁₈ hydrocarbyl group or a 3- to 18-membered non-aromatic heterocyclic group,
a divalent carbon atom at any position except the end(s) of R^{3A}, R^{3B}, R^{3C}, and R^{3D} may be replaced by -O-, -C(=O)-, -C(=O)O-, -OCO-, -CONH-, -NHCO-, -NH(C=O)O-, -S-, or -SO₂-(provided that adjacent divalent carbon atoms are not replaced at the same time);
a hydrogen atom in R^{3A}, R^{3B}, R^{3C}, and R^{3D} is, for example, (a) a halogen atom, (b) a haloalkyl group, (c) a hydroxy group, (d) a thiol group, (e) a nitro group, (f) a cyano group, (g) a carboxy group, (h) an amino group, (i) a sulfo group, (j) a group in which a hydrogen atom of a carboxy group or a hydroxy group is substituted by an acid-dissociable group, (k) a hydroxy group or a carboxy group having a protective group, or (l) a C₁₋₁₈ hydrocarbyl group, a C₁₋₁₈ hydrocarbyloxy group, a C₁₋₁₈ hydrocarbylcarbonyl group, a C₁₋₁₈ hydrocarbylcarbonyloxy group, a C₁₋₁₈ hydrocarbyloxycarbonyl group, a C₁₋₁₈ hydrocarbyloxycarbonyloxy group, or a C₁₋₁₈ hydrocarbylthio group, in which at least part of a hydrogen atom may be substituted by (a) to (k), and a divalent carbon atom at any position except the ends of these substituents may be replaced by -O-, -C(=O)-, -C(=O)O-, -OCO-, -CONH-, -NHCO-, -NH(C=O)O-, -S-, or -SO₂-(provided that adjacent divalent carbon atoms are not replaced at the same time); and
furthermore, any two of R^{3A}, R^{3B}, R^{3C}, and R^{3D} may be linked to each other directly by a single bond or via a divalent linking group -O-, -S-, -C(=O)-, -S(=O)-, -S(=O)₂-, -C(=O)O-, or a C₁₋₃ alkylene group to form a ring together with the nitrogen atom in the formula (b-3).

R^{3A}, R^{3B}, R^{3C}, and R^{3D} in the formula (b-3) preferably each independently denote an optionally substituted C₁₋₁₈ hydrocarbyl group, more preferably a C₁₋₁₂ alkyl group, a C₁₋₁₂ alkenyl group, a C₁₋₁₂ alkynyl group, or a C₁₋₁₂ alicyclic group.

Specific examples of the organic quaternary ammonium cation include a tetramethylammonium cation, a tetraethylammonium cation, a tetrapropylammonium cation, a tetrabutylammonium cation, a tetraheptylammonium cation, a trimethylethylammonium cation, a dimethyldiethylammonium cation, a dimethylethylpropylammonium cation, a methylethylpropylbutylammonium cation, a trimethylphenylammonium cation, a triethylhexylammonium cation, a triethylcyclohexylammonium cation, and a dodecyltrimethylammonium cation.

### [1-2-3. Component (B)]

The method for synthesizing the polyacid salt as the component (B) is not particularly limited and can be a known and commonly used method. The method for synthesizing the polyacid salt is, for example, a salt exchange method, an ion exchange method, or the like.

The component (B) content of the total solid component in the resist composition preferably ranges from 30% to 90% by mass, more preferably 35% to 85% by mass, still more preferably 40% to 80% by mass.

The polyacid salt contained as the component (B) in the resist composition can increase the absorption of a light source, such as DUV, XUV, or EUV. Furthermore, the component (B) can play a role of an acid diffusion control agent and an acid generator according to a relationship with the acid generator and the acid diffusion control agent. The characteristics such as acid strength can be finely adjusted by the combination of an anion moiety and a cation moiety of the polyacid salt as the component (B). Furthermore, by virtue of the component (B) functioning as an acid generator, a sulfonic acid having a carbon atom substituted by fluorine or the like need not be used as the acid generator, which is advantageous in terms of toxicity, environmental load, and the like.

### [1-3. (C) Acid Generator or Acid Diffusion Control Agent]

The resist composition according to the present embodiment may contain (C) an acid generator or an acid diffusion control agent. The component (C) can be a known and commonly used component and is not particularly limited. An acid generator (C-1) and an acid diffusion control agent (C-2) will be more specifically described below.

### [1-3-1. (C-1) Acid Generator]

The resist composition according to the present embodiment may contain (C-1) an acid generator. The acid generator may be any acid generator that can generate an acid upon exposure to light and can be a known and commonly used acid generator. By containing an acid generator in the resist composition, the acid generated upon exposure to light acts on the acid-dissociable group in the component (A) and thereby changes the solubility in a developer.

The acid generator is, for example, an onium salt compound, an N-sulfonyloxyimide compound, a sulfonimide compound, a halogen-containing compound, a diazoketone compound, or the like. Among these, an onium salt compound can be suitably used as the acid generator.

### [1-3-1-1. Onium Salt Compound]

The onium salt compound used as the acid generator is not particularly limited and may be a known and commonly used onium salt compound. As an anion moiety of the onium salt compound, a sulfonate anion can be suitably used. The sulfonate anion is not particularly limited and may be a known and commonly used sulfonate anion. A cation moiety of the onium salt compound is not particularly limited and may be a known and commonly used cation moiety. The cation moiety is, for example, but not limited to, the above-described organic sulfonium cation, organic iodonium cation, organic quaternary ammonium cation, or the like.

The onium salt compound is preferably an onium salt compound represented by the following formula (c-1).

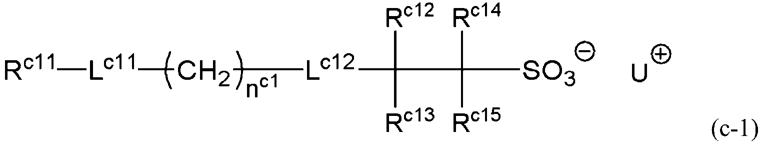

In the formula (c-1),
"R^{c11}" denotes a C₅₋₁₈ hydrocarbyl group in which one or more hydrogen atoms may be substituted by a substituent;
"R^{c12} to R^{c15}" each independently denote a hydrogen atom, a fluorine atom, or a fluorinated alkyl group with 1 to 4 carbon atoms;
"L^{c11}" denotes -O-, -C(=O)-, -C(=O)O-, -OCO-, -CONH-, -NHCO-, -NH(C=O)O-, -S-, or -SO₂-;
"L^{c12}" denotes a single bond, -O-, -C(=O)-, -C(=O)O-, -OCO-, -CONH-, -NHCO-, - NH(C=O)O-, -S-, or -SO₂-;
n^{c1} denotes an integer in the range of 0 to 4; and
"U⁺" denotes a cation moiety of the onium salt compound.

### [1-3-1-1-1. Anion Moiety of Onium Salt Compound]

In the anion moiety of the onium salt compound represented by the formula (c-1), R^{c11} preferably denotes a C₅₋₁₈ hydrocarbyl group in which one or more hydrogen atoms may be substituted by a substituent, more preferably a C₅₋₁₈ alicyclic group or a C₂₋₁₈ aryl group in which one or more hydrogen atoms may be substituted by a substituent, still more preferably a C₅₋₁₈ alicyclic group in which one or more hydrogen atoms may be substituted by a substituent, or a C₂₋₁₈ aryl group.

More specifically, the C₅₋₁₈ alicyclic group in which one or more hydrogen atoms, or the C₂₋₁₈ aryl group may be substituted by a substituent is, for example, but not limited to, a C₂₋₁₈ aryl group having a benzene skeleton, a naphthalene skeleton, an anthracene skeleton, a phenanthrene skeleton, or a biphenyl skeleton; or a C₅₋₁₈ alicyclic group having a cyclopentane skeleton, a cyclohexane skeleton, a cycloheptane skeleton, a cyclooctane skeleton, a cyclononane skeleton, a cyclodecane skeleton, a cyclododecane skeleton, a cyclopentene skeleton, a cyclohexene skeleton, a cycloheptene skeleton, a cyclooctene skeleton, a cyclodecene skeleton, a norbornane skeleton, an adamantane skeleton, a tricyclodecane skeleton, a tetracyclododecane skeleton, a norbornene skeleton, a tricyclodecene skeleton, a bicyclo[2.2.1]heptane skeleton, a bicyclo[2.2.2]octane skeleton, 9,10-dihydro-9,10-ethanoanthracene skeleton, or a 9,10-dihydro-9,10-[1,2]benzenoanthracene skeleton; or the like.

Specific examples of R^{c11} include, but are not particularly limited to, a phenyl group, a 1-naphthyl group, a 2-naphthyl group, an azulenyl group, an acenaphthyl group, a phenanthrenyl group, an anthracenyl group, a cyclopentyl group, a cyclopent-1-en-1-yl group, a 2-methylcyclopent-1-en-1-yl group, a cyclohex-1-en-1-yl group, an adamantan-1-yl group, an adamantan-2-yl group, a bicyclo[2.2.1]heptanyl group, a bicyclo[2.2.2]octanyl group, a bicyclo[2.2.1]heptenyl group, a bicyclo[2.2.2]octenyl group, a 9,10-dihydro-9,10-ethanoanthracen-11-yl group, a 9,10-dihydro-9,10-ethanoanthracen-12-yl group, a 9,10-dihydro-9,10-ethanoanthracen-9-yl group, a 9,10-dihydro-9,10-ethanoanthracen-10-yl group, a 9,10-dihydro-9.10-[1,2]benzenoanthracen-9-yl group, and a 9,10-dihydro-9,10-[1,2]benzenoanthracen-10-yl group.

In the anion moiety of the onium salt compound in the formula (c-1), R^{c12} to R^{c15} preferably each independently denote a hydrogen atom, a fluorine atom, or a fluorinated alkyl group with 1 to 4 carbon atoms; more preferably, either R^{c12} or R^{c13} denotes a hydrogen atom, a fluorine atom, or a C₁₋₂ fluorinated alkyl group, and either R^{c14} or R^{c15} denotes a fluorine atom; still more preferably, either R^{c12} or R^{c13} denotes a hydrogen atom, a fluorine atom, or a trifluoromethyl group, and both R^{c14} and R^{c15} denote a fluorine atom.

In the anion moiety of the onium salt compound in the formula (c-1), L^{c11} preferably denotes -O-, -C(=O)-, -C(=O)O-, -OCO-, -CONH-, -NHCO-, -NH(C=O)O-, -S-, or -SO₂-, more preferably -C(=O)O-, -OCO, -CONH-, or -SO₂-, still more preferably -C(=O)O- or -OCO.

In the anion moiety of the onium salt compound in the formula (c-1), L^{c12} preferably denotes a single bond, -O-, -C(=O)-, -C(=O)O-, -OCO-, -CONH-, -NHCO-, -NH(C=O)O-, -S-, or -SO₂-, more preferably a single bond, -O-, -C(=O)O-, or -OCO-, still more preferably a single bond, -C(=O)O-, or -OCO-.

### [1-3-1-1-2. Cation Moiety of Onium Salt Compound]

In the cation moiety of the onium salt compound of the formula (c-1), U⁺ is, for example, but not limited to, the above-described organic sulfonium cation, organic iodonium cation, organic quaternary ammonium cation, or the like.

As the U⁺, any of the organic sulfonium cations, organic iodonium cations, and organic quaternary ammonium cations exemplified for the component (B) can be suitably used, and among them, those exemplified as preferred can likewise be used as preferred U⁺.

### [1-3-1-2. Component (C-1)]

The component (C-1) content of the total solid component in the resist composition preferably ranges from 0.5% to 20% by mass, more preferably 1% to 15% by mass, still more preferably 2% to 12% by mass.

### [1-3-2. (C-2) Acid Diffusion Control Agent]

The resist composition according to the present embodiment may contain (C-2) an acid diffusion control agent. The acid diffusion control agent is not particularly limited and may be a known and commonly used acid diffusion control agent. The acid diffusion control agent in the resist composition can control the diffusion of an acid generated from an acid generator upon exposure to light and can suppress the progress of an undesirable reaction in an unexposed portion.

An acid diffusion control agent that can generate a weaker acid than an acid generated by an acid generator can be used to efficiently control acid diffusion. As an acid diffusion inhibitor, a carboxylate compound represented by the following formula (c-2-1) or a sulfonate compound represented by the following formula (c-2-2) is preferably used. 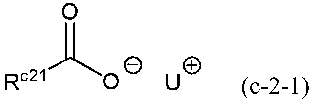 [In the formula (c-2-1), R^{c21} denotes a C₁₋₁₈ hydrocarbyl group in which one or more hydrogen atoms may be substituted by a substituent, or a 5- to 18-membered non-aromatic heterocyclic group.] 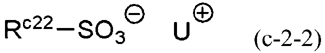 [In the formula (c-2-2), R^{c22} denotes a C₁₋₁₈ hydrocarbyl group in which one or more hydrogen atoms may be substituted by a substituent, or a 5- to 18-membered non-aromatic heterocyclic group, wherein no fluorine atom or trifluoromethyl group is bonded to the carbon atom directly bonded to the sulfur atom of the sulfonate anion.]

### [1-3-2-1. Carboxylate Compound (C-2-1)]

In the anion moiety of the carboxylate compound of the formula (c-2-1), R^{c21} preferably denotes a C₁₋₁₈ hydrocarbyl group in which one or more hydrogen atoms may be substituted by a substituent or a 5- to 18-membered non-aromatic heterocyclic group, more preferably a C₁₋₁₈ hydrocarbyl group in which one or more hydrogen atoms may be substituted by a substituent, still more preferably a C₁₋₁₂ alkyl group in which one or more hydrogen atoms may be substituted by a substituent, a C₃₋₁₈ alicyclic group, or a C₂₋₁₈ aryl group.

The carboxylate anion is, for example, but not limited to, a trifluoroacetate anion, a pentafluoropropionate anion, a 2-methoxyacetate anion, a 2-methoxy-2-methylpropionate anion, a 2-hydroxyacetate anion, a 2-hydroxy-2-methylpropionate anion, a 2-acetoxyacetate anion, an adamantane-1-carboxylate anion, a 9,10-dihydro-9,10-ethanoanthracene-11-carboxylate anion, a 9,10-dihydro-9,10-[1,2]benzenoanthracene-9-carboxylate anion, a benzoate anion, a salicylate anion, a 3-hydroxybenzoate anion, a 3-trifluoromethylbenzoate anion, or the like.

In the cation moiety of the carboxylate compound of the formula (c-2-1), U⁺ is, for example, but not limited to, the above-described organic sulfonium cation, organic iodonium cation, organic quaternary ammonium cation, or the like.

As the U⁺, any of the organic sulfonium cations, organic iodonium cations, and organic quaternary ammonium cations exemplified for the component (B) can be suitably used, and among them, those exemplified as preferred can likewise be used as preferred U⁺.

### [1-3-2-2. Sulfonate Compound]

In the anion moiety of the sulfonate compound of the formula (c-2-2), R^{c22} preferably denotes a C₁₋₁₈ hydrocarbyl group in which one or more hydrogen atoms may be substituted by a substituent or a 5- to 18-membered non-aromatic heterocyclic group, wherein no fluorine atom or trifluoromethyl group is bonded to the carbon atom directly bonded to the sulfur atom of the sulfonate anion, more preferably a C₁₋₁₈ hydrocarbyl group in which one or more hydrogen atoms may be substituted by a substituent, still more preferably a C₁₋₁₂ alkyl group in which one or more hydrogen atoms may be substituted by a substituent, a C₃₋₁₈ alicyclic group, or a C₂₋₁₈ aryl group.

The sulfonate anion is, for example, but not limited to, a camphorsulfonate anion, an (adamantan-1-yl)methanesulfonate anion, an (adamantane-1-carbonyloxy)ethane-1-sulfonate anion, a cyclohexane sulfonate anion, a 2-(cyclohexanecarbonyloxy)ethane-1-sulfonate anion, a bicyclo[2.2.1]heptane-2-sulfonate anion, a benzenesulfonate anion, a 4-methylbenzenesulfonate anion, or the like.

In the cation moiety of the sulfonate compound of the formula (c-2-2), U⁺ is, for example, but not limited to, the above-described organic sulfonium cation, organic iodonium cation, organic quaternary ammonium cation, or the like.

As the U⁺, any of the organic sulfonium cations, organic iodonium cations, and organic quaternary ammonium cations exemplified for the component (B) can be suitably used, and among them, those exemplified as preferred can likewise be used as preferred U⁺.

### [1-3-2-3. (C-2) Component]

The component (C-2) content of the total solid component in the resist composition preferably ranges from 0.5% to 25% by mass, more preferably 1% to 20% by mass, still more preferably 5% to 15% by mass.

### [1-4. Organic Solvent]

The resist composition according to the present embodiment may further contain an organic solvent. The organic solvent is not particularly limited and may be a known and commonly used organic solvent. The organic solvent is preferably an organic solvent that can uniformly dissolve or disperse the component (A), the component (B), and the component (C-1) or the component (C-2) when these components are prepared.

The organic solvent is, for example, an alcohol solvent, an ether solvent, a ketone solvent, an amide solvent, an ester solvent, a hydrocarbon solvent, or the like. These organic solvents may be used alone or in combination of two or more types thereof.

More specifically, the organic solvent is, for example, an alcohol solvent, such as methanol, ethanol, 3-methoxybutanol, 3-methyl-3-methoxybutanol, 1-methoxy-2-propanol, 4-methyl-2-pentanol, ethylene glycol, diethylene glycol, propylene glycol, or dipropylene glycol; an ether solvent, such as diethyl ether, dipropyl ether, dibutyl ether, diisoamyl ether, tetrahydrofuran, anisole, propylene glycol monomethyl ether (PGME), propylene glycol monoethyl ether, ethylene glycol monomethyl ether, or ethylene glycol monoethyl ether; a ketone solvent, such as acetone, methyl ethyl ketone, cyclohexanone, methyl n-pentyl ketone, methyl isopentyl ketone, 2-heptanone, and acetophenone; an amide solvent, such as N,N-dimethylformamide, N,N-diethylformamide, or acetamide; an ester solvent, such as methyl lactate, ethyl lactate (EL), methyl acetate, ethyl acetate, methyl pyruvate, ethyl pyruvate, methyl methoxypropionate, or propylene glycol monomethyl ether acetate (PGMEA); a hydrocarbon solvent, such as n-pentane, n-hexane, toluene, or xylene; or γ-butyrolactone, δ-valerolactone, γ-lactam, δ-lactam, dimethyl sulfoxide (DMSO), or the like.

These organic solvents may be used alone or in combination of two or more types thereof.

An organic solvent to be contained in the resist composition according to the present embodiment is preferably PGMEA, PGME, γ-butyrolactone, EL, or cyclohexanone.

Furthermore, a mixed solvent of PGMEA and a polar solvent can also be suitably used. The blend ratio (mass ratio) of the mixed solvent can be determined appropriately in consideration of the type of polar solvent and the compatibility of PGMEA and the polar solvent. The blend ratio (mass ratio) of the mixed solvent preferably ranges from 1:9 to 9:1, more preferably 2:8 to 8:2.

The polar solvent is, for example, EL, cyclohexanone, or the like.

The organic solvent content of the resist composition is not particularly limited and can be appropriately determined according to the method for applying the resist composition to a substrate or the like, the thickness of the coating film, and the like. The organic solvent content of the resist composition is such that the solid concentration of the resist composition preferably ranges from 0.1% to 20% by mass, more preferably 0.2% to 15% by mass.

### [1-5. Others]

If desired, the resist composition according to the present embodiment can appropriately contain, as a miscible additive agent, for example, an additional resin for improving the performance of a resist film, a dissolution inhibitor, a plasticizer, a stabilizer, a colorant, an antihalation agent, a dye, or the like.

### [2. Pattern Forming Method]

The pattern forming method according to the present embodiment includes a step of applying a resist composition to a substrate, a step of exposing a resist film formed by the application step to light, and a step of developing the exposed resist film.

### [2-1. Application Step]

The pattern forming method according to the present embodiment includes the step of applying a resist composition to a substrate.

### <Substrate>

The substrate used in the present embodiment is not particularly limited and can be a known and commonly used substrate. The substrate is, for example, a substrate for an electronic component, a substrate on which a predetermined wiring pattern is formed, or the like

The material of the substrate is, for example, but not limited to, a silicon wafer, a substrate made of a metal, such as copper, chromium, iron, or aluminum, a substrate made of an inorganic substance, such as glass, titanium oxide, or silicon dioxide, or the like.

The substrate may have any size, shape, and the like, may have a smooth, curved, or rough surface, and may be a flaky substrate or the like.

The surface of the substrate may be subjected to a surface treatment as necessary. In the case of a substrate having a hydroxy group on a surface layer thereof, the surface of the substrate may be treated with a silane coupling agent capable of reacting with the hydroxy group to change the surface layer of the substrate from hydrophilic to hydrophobic, thereby enhancing the adhesion between the substrate and a film containing a metal compound. The silane coupling agent is, for example, hexamethyldisilazane (HMDS) or the like.

### <Application Method>

The method for applying the resist composition to a substrate is not particularly limited and can be a known and commonly used method. The application method includes a dry method, for example, a chemical vapor deposition (CVD) method, such as thermal CVD, plasma CVD, or photo-CVD; a physical vapor deposition (PVD) method, such as vacuum deposition, plasma-assisted vapor deposition, sputtering, or ion plating; or the like. A wet method, for example, a coating method, such as spin coating, bar coating, roll coating, flow coating, dip coating, spray coating, ink jet printing, or screen printing, can also be used.

From the perspective of forming a film with a uniform thickness or the like, the method for applying the resist composition according to the present embodiment to a substrate is preferably a wet method, such as a spin coating method or screen printing, more preferably a spin coating method.

A resist film formed by applying the resist composition to a substrate may be dried by any method, for example, using a heater (post-apply bake (PAB)), such as a hot plate, or a pressure reduction apparatus.

The baking conditions are not particularly limited and can be appropriately determined according to the type, application, and the like of the resist film. The baking temperature preferably ranges from 80°C to 350°C, more preferably 100°C to 300°C, still more preferably 120°C to 250°C. The baking time preferably ranges from 10 seconds to 10 minutes, more preferably 20 seconds to 5 minutes, still more preferably 30 seconds to 200 seconds.

The thickness of the resist film after drying is preferably, but not limited to, in the range of 0.5 to 100 nm, more preferably 1 to 75 nm, still more preferably 1 to 60 nm.

### [2-2. Exposure Step]

The pattern forming method according to the present embodiment includes a step of exposing the resist film formed by the application step to light.

As an exposure apparatus in the exposure step of the resist film, for example, an ArF exposure apparatus, an electron-beam lithography system, an EUV exposure apparatus, or the like can be used. Furthermore, in the exposure step, exposure may be performed through a mask (mask pattern) on which a predetermined pattern is formed, or selective exposure may be performed by drawing or the like by direct irradiation with an electron beam without using a mask pattern.

The exposure wavelength is not particularly limited, and radiation, such as an ArF excimer laser (wavelength: 193 nm), a KrF excimer laser (248 nm), an F₂ excimer laser (wavelength: 157 nm), extreme ultraviolet (EUV), vacuum ultraviolet (VUV), an electron beam (EB), X-rays, soft X-rays, or the like may be used.

For an ArF excimer laser or a KrF excimer laser, the exposure level on the resist film preferably ranges from 1 to 100 mJ/cm², more preferably 20 to 60 mJ/cm². Furthermore, for extreme ultraviolet, the exposure level is preferably 500 mJ/cm² or less, more preferably 0.1 to 200 mJ/cm², still more preferably 3 to 100 mJ/cm². For an electron beam, the exposure level preferably ranges from 0.1 to 20 µC/cm², more preferably 3 to 10 µC/cm².

After the resist film is exposed to light, a baking (post-exposure bake (PEB)) treatment may be performed. The baking conditions are not particularly limited and can be appropriately determined according to the type, application, and the like of the resist film. The baking temperature preferably ranges from 50°C to 350°C, more preferably 60°C to 250°C, still more preferably 80°C to 200°C, using a heater, such as a hot plate. The baking time preferably ranges from 10 seconds to 10 minutes, more preferably 20 seconds to 5 minutes, still more preferably 30 seconds to 200 seconds.

### [2-3. Development Step]

The pattern forming method according to the present embodiment includes the step of developing the exposed resist film. In the development step, the exposed resist film can be developed with a developer to form a pattern. Furthermore, the development may be followed by washing with a rinse liquid and drying, and in some cases, further followed by a baking treatment.

### <Developer>

As the developer used in the present embodiment, an alkaline developer is used for alkaline development, and a developer containing an organic solvent is used for solvent development.

The alkaline developer used for alkaline development is, for example, an alkaline developer containing at least one of sodium hydroxide, potassium hydroxide, sodium carbonate, sodium silicate, sodium metasilicate, aqueous ammonia, ethylamine, n-propylamine, diethylamine, di-n-propylamine, triethylamine, methyldiethylamine, ethyldimethylamine, triethanolamine, and tetramethylammonium hydroxide (TMAH). Among these, the alkaline developer is preferably a TMAH aqueous solution, more preferably a 0.1% to 10% by mass TMAH aqueous solution, still more preferably a 0.5% to 5% by mass TMAH aqueous solution.

The solvent developer used for solvent development is, for example, a developer containing at least one of a polar solvent, such as a ketone solvent, an ester solvent, an alcohol solvent, a nitrile solvent, an amide solvent, or an ether solvent, and an organic solvent, such as a hydrocarbon solvent.

Among these, the organic solvent used in the solvent developer is preferably a polar solvent, more preferably a ketone solvent, an ester solvent, or a nitrile solvent.

The ketone solvent is, for example, 1-octanone, 2-octanone, 1-nonanone, 2-nonanone, acetone, 4-heptanone, 1-hexanone, 2-hexanone, diisobutyl ketone, cyclohexanone, methylcyclohexanone, phenylacetone, methyl ethyl ketone, methyl isobutyl ketone, acetylacetone, acetonylacetone, diacetone alcohol, 1-hydroxyacetone, acetophenone, methyl naphthyl ketone, 2-heptanone, or the like.

The ester solvent is, for example, methyl acetate, butyl acetate, ethyl acetate, isopropyl acetate, amyl acetate, isoamyl acetate, ethyl methoxyacetate, ethyl ethoxyacetate, ethylene glycol monomethyl ether acetate, ethylene glycol monoethyl ether acetate, ethylene glycol monopropyl ether acetate, ethylene glycol monobutyl ether acetate, ethylene glycol monophenyl ether acetate, diethylene glycol monomethyl ether acetate, diethylene glycol monoethyl ether acetate, diethylene glycol monopropyl ether acetate, diethylene glycol monophenyl ether acetate, diethylene glycol monobutyl ether acetate, 2-methoxybutyl acetate, 3-methoxybutyl acetate, 4-methoxybutyl acetate, 3-methyl-3-methoxybutyl acetate, 3-ethyl-3-methoxybutyl acetate, propylene glycol monomethyl ether acetate, propylene glycol monoethyl ether acetate, propylene glycol monopropyl ether acetate, 2-ethoxybutyl acetate, 4-ethoxybutyl acetate, 4-propoxybutyl acetate, 2-methoxypentyl acetate, 3-methoxypentyl acetate, 4-methoxypentyl acetate, 2-methyl-3-methoxypentyl acetate, 3-methyl-3-methoxypentyl acetate, 3-methyl-4-methoxypentyl acetate, 4-methyl-4-methoxypentyl acetate, propylene glycol diacetate, methyl formate, ethyl formate, propyl formate, butyl formate, ethyl lactate, propyl lactate, butyl lactate, methyl pyruvate, ethyl pyruvate, propyl pyruvate, butyl pyruvate, methyl acetoacetate, ethyl acetoacetate, propyl acetoacetate, methyl propionate, ethyl propionate, propyl propionate, isopropyl propionate, methyl 2-hydroxypropionate, ethyl 2-hydroxypropionate, methyl-3-methoxypropionate, ethyl-3-methoxypropionate, ethyl-3-ethoxypropionate, propyl-3-methoxypropionate, or the like.

The nitrile solvent is, for example, acetonitrile, propionitrile, butyronitrile, valeronitrile, or the like.

The method for developing the exposed resist film using the developer is not particularly limited and can be a known and commonly used method. The method of developing using the developer is, for example, a method of immersing the substrate having the exposed resist film in the developer for a certain period (dip method), a method of spraying the developer on the surface of the exposed resist film (spray method), a method of discharging the developer from a discharge nozzle at a constant speed toward the surface of the exposed resist film on the substrate rotating at a constant speed (dynamic dispense method), or the like.

### <Rinse Liquid>

The development with the solvent developer may be followed by a step of washing with a rinse liquid. The rinse liquid is not particularly limited and may be a known and commonly used rinse liquid. As the rinse liquid, among the organic solvent(s) in the solvent developer, a solvent that is less likely to dissolve the resist pattern can be appropriately selected and used.

The rinse liquid is, for example, but not limited to, at least one organic solvent selected from the group consisting of a hydrocarbon solvent, a ketone solvent, an ester solvent, an alcohol solvent, an amide solvent, and an ether solvent. Among these, the rinse liquid is preferably at least one organic solvent selected from the group consisting of a hydrocarbon solvent, a ketone solvent, an ester solvent, an alcohol solvent, and an amide solvent, more preferably at least one selected from the group consisting of an alcohol solvent and an ester solvent, still more preferably at least one alcohol solvent.

The alcohol solvent used in the rinse liquid is preferably a monohydric alcohol with 6 to 8 carbon atoms, and the monohydric alcohol may be linear, branched, or cyclic. Specific examples of the monohydric alcohol include 1-hexanol, 1-heptanol, 1-octanol, 2-hexanol, 2-heptanol, 2-octanol, 3-hexanol, 3-heptanol, 3-octanol, 4-octanol, and benzyl alcohol.

These organic solvents may be used alone or in combination of two or more types thereof.

In addition to the organic solvents described above, the rinse liquid may further include an organic solvent other than the organic solvents described above or water. In a case where the rinse liquid contains water, the water content is preferably 30% or less by mass, more preferably 10% or less by mass, still more preferably 5% or less by mass, particularly preferably 3% or less by mass, relative to the total amount of the rinse liquid.

The method for washing the resist pattern with the rinse liquid is not particularly limited and can be a known and commonly used method. The method of washing using the rinse liquid is, for example, a method of immersing the resist pattern in the rinse liquid for a certain period (dip method), a method of spraying the rinse liquid onto the surface of the resist pattern (spray method), and a method of discharging the rinse liquid from a discharge nozzle at a constant speed toward the surface of the resist pattern rotating at a constant speed (dynamic dispense method), or the like.

### EXAMPLES

The present invention will be more specifically described below with reference to examples, but the present invention is not limited to these examples.

### [1. Synthesis of Component (B)]

### <Synthesis Example 1: hexakis(bis(2-trifluoromethylphenyl)phenylsulfonium)metatungstate (B-1)>

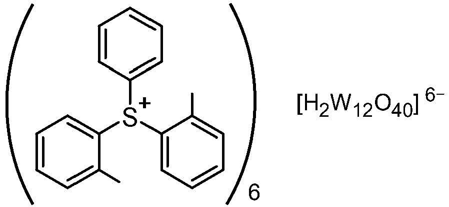

6.68 g of bis(2-trifluoromethylphenyl)phenylsulfonium chloride was dissolved in 99.36 g of pure water, 6.88 g of an ammonium metatungstate.: an ammonium metatungstate hydrate ((NH4)6[H2W12O40]·xH2O)) was added thereto, and the reaction liquid was stirred at room temperature for 30 minutes. A powder produced by filtering the reaction liquid was dried under reduced pressure at room temperature for 18 hours. The dried powder was dissolved in 100 g of dimethylformamide, 335 g of methanol was then added thereto, and a target compound was produced by crystallization at room temperature.
¹H-NMR (400 MHz, DMSO-D6): δ (ppm) =5.97(s, 0.33H), 7.65 - 8.35(m, 13H).
¹⁸³W-NMR (20.84 MHz, DMSO-D6): δ (ppm) = -100.13(s, 12W).
ESI-MS: POSITIVE m/z 399.1 ([C₂₀H₁₃F₆S]⁺)
   NEGATIVE m/z 712.3 (median) ([H₄W₁₂O₄₀]⁴⁻)

### <Synthesis Example 2: tris(phenyl bis(2-(trifluoromethyl)phenyl)sulfonium)phosphotungstate (B-2)>

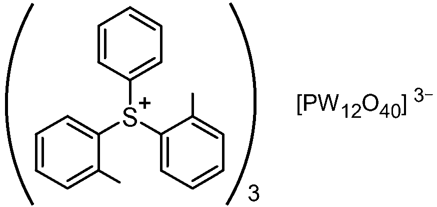

27.95 g of phenyl bis(2-(trifluoromethyl)phenyl)sulfonium chloride was dissolved in 50 g of cyclohexanone, 41.97 g of phosphotungstic acid (H₃[PW₁₂O₄₀]·30H₂O) was added thereto, and the reaction liquid was stirred at room temperature for 2 hours. A powder produced by filtering the reaction liquid was dried under reduced pressure at room temperature for 18 hours. The dried powder was crystallized at room temperature using dichloromethane and acetonitrile to produce a target compound.
¹H-NMR (400 MHz, DMSO-D6): δ (ppm) =7.63 - 8.36(m, 39H).
¹⁸³W-NMR (20.84 MHz, DMSO-D6): δ (ppm) = -86.7(s, 12W).
ESI-MS: NEGATIVE m/z 959 (median) ([PW₁₂O₄₀]³⁻)

### <Synthesis Example 3: tetrakis(phenyl bis(2-(trifluoromethyl)phenyl)sulfonium)silicotungstate (B-3)>

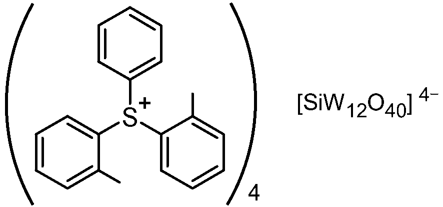

37.26 g of phenyl bis(2-(trifluoromethyl)phenyl)sulfonium chloride was dissolved in 50 g of cyclohexanone, 41.06 g of silicotungstic acid (H₄[SiW₁₂O₄₀]·26H₂O) was added thereto, and the reaction liquid was stirred at room temperature for 2 hours. A powder produced by filtering the reaction liquid was dried under reduced pressure at room temperature for 18 hours. The dried powder was crystallized at room temperature using dichloromethane and acetonitrile to produce a target compound.
¹H-NMR (400 MHz, DMSO-D6): δ (ppm) = 7.63-8.34 (m, 52H).
¹⁸³W-NMR (20.84 MHz, DMSO-D6): δ (ppm) = -92.7 (s, 12W).
ESI-MS: NEGATIVE m/z 718.5 (median) ([SiW₁₂O₄₀]⁴⁻)

### <Synthesis Example 4: tris(bis(3.5-difluorophenyl)phenylsulfonium)phosphotungstate (B-4)>

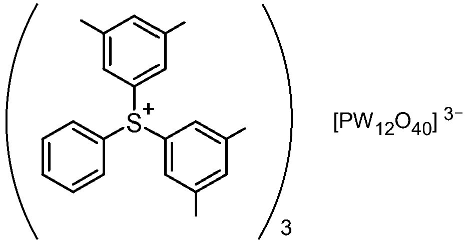

41.26 g of bis(3.5-difluorophenyl)phenylsulfonium chloride was dissolved in 50 g of cyclohexanone, 41.97 g of phosphotungstic acid (H₃[PW₁₂O₄₀]·30H₂O) was added thereto, and the reaction liquid was stirred at room temperature for 2 hours. A powder produced by filtering the reaction liquid was dried under reduced pressure at room temperature for 18 hours. The dried powder was crystallized at room temperature using dichloromethane and acetonitrile to produce a target compound.
¹H-NMR (400 MHz, DMSO-D6): δ (ppm) = 7.63 - 7.98(m, 33H).
¹⁸³W-NMR (20.84 MHz, DMSO-D6): δ (ppm) = -86.7 (s, 12W).
ESI-MS: NEGATIVE m/z 959 (median) ([PW₁₂O₄₀]³⁻)

### <Synthesis Example 5: tris(bis(4-tert-butylphenyl)iodonium)phosphotungstate (B-5)>

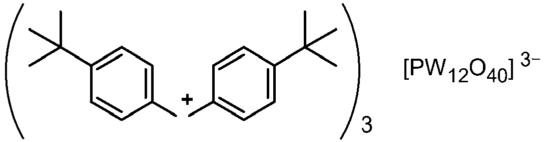

27.57 g of bis(4-tert-butylphenyl)iodonium chloride was dissolved in 50 g of cyclohexanone, 41.97 g of phosphotungstic acid (H₃[PW₁₂O₄₀]·30H₂O) was added thereto, and the reaction liquid was stirred at room temperature for 2 hours. A powder produced by filtering the reaction liquid was dried under reduced pressure at room temperature for 18 hours. The dried powder was crystallized at room temperature using dichloromethane and acetonitrile to produce a target compound.
¹H-NMR (400 MHz, DMSO-D6): δ (ppm) = 8.19(d, 12H), 7.51(d, 12H), 1.22(s, 54H).
¹⁸³W-NMR (20.84 MHz, DMSO-D6): δ (ppm) = -86.7 (s, 12W).
ESI-MS: NEGATIVE m/z 959 (median) ([PW₁₂O₄₀]³⁻)

### [2. Evaluation of Component (B) as Acid Generator]

### [2-1. Preparation of Test Resist Composition]

Test resist compositions R1-1 to R1-6 were prepared by blending the components (A), (B), (C-1), and (C-2) in the amounts (unit: parts by mass) shown in Table 1 and adjusting the solid concentration of each test resist composition to 1.15% by mass using an organic solvent (S-1) (propylene glycol methyl ether acetate: dimethylformamide: ethyl lactate = 3:17:80). Furthermore, a test resist composition R1-7 was prepared by blending the components (A) and (B) in amounts (unit: parts by mass) shown in Table 1 below and adjusting the solid concentration of the test resist composition to 0.20% by mass using an organic solvent (S-2) (propylene glycol methyl ether acetate:cyclohexanone = 95:5).

The details of the components (A), (C-1), and (C-2) described in Table 1 are as described below. The component (B) was each of polyacid salts B-1 to B-5 synthesized above. The blending amount of each component is a value in terms of solid content.

### <Component (A)>

- A-1: A resin prepared by copolymerizing a structural unit (a1-1-1) having an acid-dissociable group represented by the following formula (A-1) and a structural unit (a2-1-1) having a phenolic hydroxy group (the mole ratio of (a1-1-1) to (a2-1-1) is 60:40). The standard polystyrene-equivalent weight-average molecular weight (Mw) determined by GPC measurement was 7000. 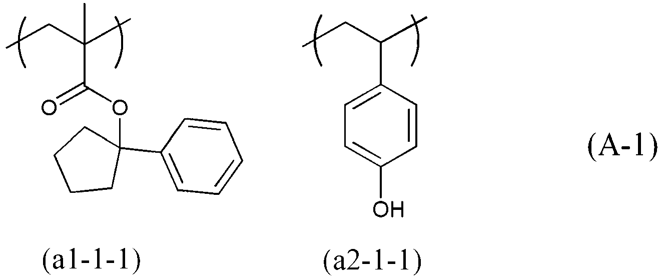
- A-2: A resin prepared by copolymerizing a structural unit (a1-1-2) having an acid-dissociable group, a structural unit (a3-1-1) having a lactone-containing alicyclic group, and a structural unit (a4-1-1) having a polar group-containing hydrocarbyl group, represented by the following formula (A-2) (the mole ratio of (a1-1-2) to (a3-1-1) to (a4-1-1) is 40:40:20). The standard polystyrene-equivalent Mw determined by GPC measurement was 10,000.

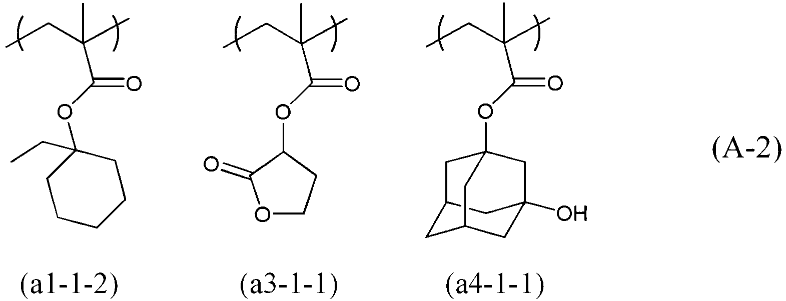

### <Component (C-1)>

- C-1-1: An acid generator that is a salt of a 2-((adamantane-1-carbonyl)oxy)-1,1-difluoroethane-1-sulfonate anion and a phenyl bis(2-(trifluoromethyl)phenyl)sulfonium cation, represented by the following formula (C-1-1).

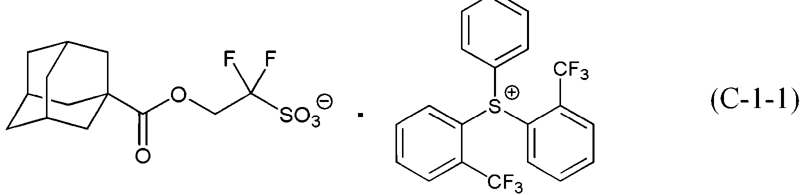

### <Component (C-2)>

- C-2-1: An acid diffusion control agent that is a salt of a salicylic acid anion and a phenyl bis(2-(trifluoromethyl)phenyl)sulfonium cation, represented by the following formula (C-2-1).

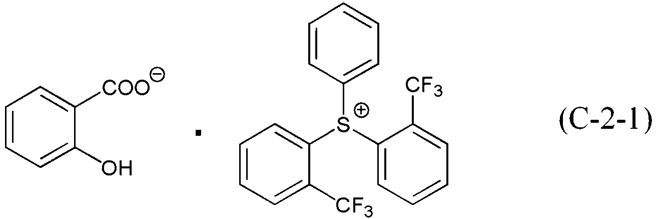

**[Table 1]**

| Component | | R1-1 | R1-2 | R1-3 | R1-4 | R1-5 | R1-6 | R1-7 |
|---|---|---|---|---|---|---|---|---|
| (A) | A-1 | 100 | 100 | 100 | 100 | 100 | 100 | |
| | A-2 | | | | | | | 100 |
| (B) | B-1 | | 165.9 | | | | | |
| | B-2 | | | 139.0 | | | | 10 |
| | B-3 | | | | 152.5 | | | |
| | B-4 | | | | | 132.4 | | |
| | B-5 | | | | | | 138.3 | |
| (C-1) | C-1-1 | 27.0 | | | | | | |
| (C-2) | C-2-1 | 33.1 | 33.1 | 33.1 | 33.1 | 33.1 | 33.1 | |

### [2-2. Preparation (KrF Exposure Apparatus), Development, and Evaluation of Test Film]

### <Preparation of Test Film>

Each of the test resist compositions R1-1 to R1-6 was applied using a spinner (1500 rpm) to an 8-inch silicon substrate subjected to a hexamethyldisilazane (HDMS) treatment, was subjected to a post-apply bake (PAB) treatment on a hot plate at a temperature of 110°C for 60 seconds, and was dried to form a resist film with a thickness of 25 nm. The average thickness of the formed resist film was measured with a thickness measuring apparatus ("M-2000D" manufactured by J. A. Woollam).

Using a KrF exposure apparatus ("NSR-S203B" manufactured by Nikon Corporation, numerical aperture (NA) = 0.68, σ = 0.75), the resist film was exposed to light by open-frame exposure at different exposure levels of 0 mJ/cm² (unexposed), 5 mJ/cm², 10 mJ/cm², and 60 mJ/cm².

After the exposure to light, a post-exposure bake (PEB) treatment was performed at 100°C for 60 seconds to prepare test films M1-1 to M1-6.

### <Development of Test Film and Evaluation Thereof>

The test films were subjected to alkaline development at 23°C for 60 seconds using a 2.38% by mass TMAH aqueous solution (trade name "NMD-3": manufactured by Tokyo Ohka Kogyo Co., Ltd.). Rinsing with pure water was then performed for 15 seconds.

The thickness (average thickness) of each test film after the development was measured with the thickness measuring apparatus, and the results were shown in Table 2.

**[Table 2]**

| Test film | Exposure level | | | |
|---|---|---|---|---|
| | 0 mJ/cm² | 5 mJ/cm² | 10 mJ/cm² | 60 mJ/cm² |
| M1-1 | 25 nm | 24 nm | 7 nm | < 2 nm |
| M1-2 | 24 nm | 24 nm | 22 nm | < 2 nm |
| M1-3 | 24 nm | 24 nm | 15 nm | < 2 nm |
| M1-4 | 26 nm | 24 nm | 20 nm | < 2 nm |
| M1-5 | 25 nm | 23 nm | 10 nm | < 2 nm |
| M1-6 | 24 nm | 23 nm | 12 nm | < 2 nm |

Table 2 shows that to change the solubility of the component (A) in the developer, the case where the component (B), which generates a slightly weaker acid, is used as an acid generator, requires a higher exposure level than the case where C-1-1 is used as an acid generator.

In the component (B), it is generally known that pKa values is phosphotungstic acid < silicotungstic acid < metatungstic acid. It is shown that to change the solubility of the component (A) in the developer, M1-4, which contains an acid generator in which the anion moiety of the component (B) is a silicotungstate anion, and M1-2, which contains an acid generator in which the anion moiety of the component (B) is a metatungstate anion, require a higher exposure level than M1-3, M1-5, and M1-6, which contain an acid generator in which the anion moiety of the component (B) is a phosphotungstate anion.

Furthermore, it is shown that the exposure level required to change the solubility of the component (A) in the developer can be finely adjusted by changing the cation moiety of the component (B) to phenyl bis(2-(trifluoromethyl)phenyl)sulfonium, bis(3,5-difluorophenyl)phenylsulfonium, or bis(4-tert-butylphenyl)iodonium, as in M1-3, M1-5, and M1-6, changing the type of the onium cation, and changing a substituent, such as an electron-withdrawing group or an electron-donating group, on the onium cation.

Thus, the results in Table 2 show that the acid strength, the sensitivity, such as the exposure level required to change the solubility of the component (A) in the developer, and the resolution can be appropriately adjusted by the combination of the anion moiety and the cation moiety of the component (B).

### [2-3. Preparation (ArF Exposure Apparatus), Development, and Evaluation of Test Film]

### <Preparation of Test Film>

An organic antireflection film material was applied to a 12-inch silicon substrate using a spinner and was heat-treated on a hot plate at a temperature of 205°C for 60 seconds to form an antireflection film with a thickness of 85 nm. The test resist composition R1-7 was then applied using a spinner (1500 rpm), was subjected to a post-apply bake (PAB) treatment on a hot plate at a temperature of 110°C for 60 seconds, and was dried to form a resist film with a thickness of 100 nm. The average thickness of the formed resist film was measured with the thickness measuring apparatus ("M-2000D" manufactured by J. A. Woollam).

The resist film was exposed to light using an ArF exposure apparatus ("NSR-S-308F" manufactured by Nikon Corporation, numerical aperture (NA) = 0.92, σ = 0.95).

After the exposure to light, a post-exposure bake (PEB) treatment was performed at 130°C for 60 seconds.

### <Development of Test Film and Evaluation Thereof>

The test films were subjected to alkaline development at 23°C for 60 seconds using a 2.38% by mass TMAH aqueous solution (trade name "NMD-3": manufactured by Tokyo Ohka Kogyo Co., Ltd.). Rinsing with pure water was then performed for 15 seconds.

The size of the substrate thus produced was measured with an electron microscope CG-5000 manufactured by Hitachi High-Tech Corporation, and it was found that a 100-nm line and space pattern was resolved at an exposure level of 40 mJ/cm².

It was confirmed from the above that the component (B) according to the present invention functions as an acid generator even when used alone.

### [3. Evaluation of Component (B) as Acid Diffusion Control Agent]

### [3-1. Preparation of Test Resist Composition]

Test resist compositions R2-1 to R2-6 were prepared by blending the components (A), (B), and (C-1) in the amounts (unit: parts by mass) shown in Table 3 and adjusting the solid concentration of each test resist composition to 1.15% by mass using an organic solvent (S-1) (propylene glycol methyl ether acetate: dimethylformamide: ethyl lactate = 3:17:80).

The details of the components (A), (B), and (C-1) described in Table 3 are as described above. The blending amount of each component is a value in terms of solid content.

**[Table 3]**

| Component | | R2-1 | R2-2 | R2-3 | R2-4 | R2-5 | R2-6 |
|---|---|---|---|---|---|---|---|
| (A) | A-1 | 100 | 100 | 100 | 100 | 100 | 100 |
| (B) | B-1 | | 299.7 | | | | |
| | B-2 | | | 251.1 | | | |
| | B-3 | | | | 275.5 | | |
| | B-4 | | | | | 239.3 | |
| | B-5 | | | | | | 250 |
| (C-1) | C-1-1 | 27.0 | 27.0 | 27.0 | 27.0 | 27.0 | 27.0 |

### [3-2. Preparation of Test Film]

Test films M2-1 to M2-6 were prepared using the test resist compositions R2-1 to R2-6 in the same manner as described above.

### [3-3. Development and Evaluation of Test Film]

The test films were subjected to alkaline development at 23°C for 60 seconds using a 2.38% by mass TMAH aqueous solution (trade name "NMD-3": manufactured by Tokyo Ohka Kogyo Co., Ltd.). Rinsing with pure water was then performed for 15 seconds.

The thickness (average thickness) of each test film after the development was measured with the thickness measuring apparatus, and the results were shown in Table 4.

**[Table 4]**

| Test film | Exposure level | | | |
|---|---|---|---|---|
| | 0 mJ/cm² | 5 mJ/cm² | 10 mJ/cm² | 60 mJ/cm² |
| M2-1 | 23 nm | < 2 nm | < 2 nm | < 2 nm |
| M2-2 | 25 nm | 24 nm | 20 nm | < 2 nm |
| M2-3 | 25 nm | 24 nm | 18 nm | < 2 nm |
| M2-4 | 24 nm | 24 nm | 20 nm | < 2 nm |
| M2-5 | 25 nm | 25 nm | 15 nm | < 2 nm |
| M2-6 | 26 nm | 25 nm | 16 nm | < 2 nm |

A comparison of the results for M1-1 in Table 2 with the results for M2-1 in Table 4 shows that in M2-1, which contained the acid generator C-1-1 but did not contain the acid diffusion control agent C-2-1, the solubility of the component (A) in the developer changed at a lower exposure level than in M1-1, which contained the acid generator C-1-1 and the acid diffusion control agent C-2-1.

On the other hand, as can be seen from the results of M2-2 to M2-6 in Table 4, in a case where a predetermined amount of the compound (B) is contained as shown in Table 4, a higher exposure level is required to change the solubility of the component (A) in the developer as compared with the case of M2-1, and the diffusion of the acid generated from the acid generator C-1-1 is controlled.

Thus, the results in Table 4 show that the component (B) can also be useful as an acid diffusion control agent.

Furthermore, as described above, it is generally known that pKa values are phosphotungstic acid < silicotungstic acid < metatungstic acid. Furthermore, it can be seen that, compared with M2-3, M2-5, and M2-6 containing an acid generator in which the anion moiety of the component (B) is a phosphotungstate anion, M2-2 containing an acid generator in which the anion moiety of the component (B) is a metatungstate anion and M2-4 containing an acid generator in which the anion moiety of the component (B) is a silicotungstate anion require a higher exposure level to change the solubility of the component (A) in the developer. This is considered to be due to the fact that the metatungstate anion or the silicotungstate anion having a larger pKa value has a higher ability to retain a proton than the phosphotungstate anion.

Furthermore, it is shown that the exposure level required to change the solubility of the component (A) in the developer can be finely adjusted by changing the cation moiety of the component (B) to phenyl bis(2-(trifluoromethyl)phenyl)sulfonium, bis(3,5-difluorophenyl)phenylsulfonium, or bis(4-tert-butylphenyl)iodonium, as in M2-3, M2-5, and M2-6, changing the type of the onium cation, and changing a substituent, such as an electron-withdrawing group or an electron-donating group, on the onium cation. This is probably because, when the component (B) functions as an acid diffusion control agent, an equilibrium state is formed depending on which of the cation moiety of the component (B) and a proton is more likely to be bonded to the anion moiety of the component (B).

Thus, the results in Table 4 show that the strength of the component (B) as an acid diffusion control agent, the sensitivity, such as the exposure level required to change the solubility of the component (A) in the developer, and the resolution can be appropriately finely adjusted by the combination of the anion moiety and the cation moiety of the component (B).

## Claims

1. A resist composition comprising:
(A) a resin component whose solubility in a developer changes by the action of an acid; and
(B) a polyacid salt.

2. The resist composition according to claim 1, wherein an anion moiety of the (B) polyacid salt is a polyoxomolybdate anion, a polyoxotungstate anion, a polyoxoniobate anion, or a polyoxotantalate anion.

3. The resist composition according to claim 1, wherein a cation moiety of the (B) polyacid salt is an organic sulfonium cation, an organic iodonium cation, or an organic quaternary ammonium cation.

4. The resist composition according to claim 1, wherein the (B) polyacid salt is a salt of a polyoxomolybdate anion, a polyoxotungstate anion, a polyoxoniobate anion, or a polyoxotantalate anion, and an organic sulfonium cation, an organic iodonium cation, or an organic quaternary ammonium cation.

5. The resist composition according to claim 1, further comprising (C) an acid generator or an acid diffusion control agent.

6. A pattern forming method comprising the steps of:
applying the resist composition according to any one of claims 1 to 5 to a substrate to form a resist film;
exposing the resist film to light; and
developing the exposed resist film with a developer.
